# EUROPÄISCHE PATENTSCHRIFT

(11) **EP 1 342 318 B1**
(45) Veröffentlichungstag und Bekanntmachung des Hinweises auf die Patenterteilung: **10.10.2007**
(21) Anmeldenummer: 01270184.3
(22) Anmeldetag: 03.12.2001
(51) Int. Cl.: H03K 17/082

(54) **ELEKTRONISCHE SCHALTEINRICHTUNG**
ELECTRONIC SWITCHING DEVICE
CIRCUIT ELECTRONIQUE

(30) Priorität: 13.12.2000 DE 10062026
(43) Veröffentlichungstag der Anmeldung: 10.09.2003
(73) Patentinhaber: SIEMENS AKTIENGESELLSCHAFT, 80333 München (DE)
(72) Erfinder: Friedrichs, Peter, 90475 Nürnberg (DE); Griepentrog, Gerd, 91468 Gutenstetten (DE); Maier, Reinhard, 91074 Herzogenaurach (DE); Mitlehner, Heinz, 91080 Uttenreuth (DE); Schörner, Reinhold, 91091 Grossenseebach (DE)
(86) Internationale Anmeldenummer: PCT/DE2001/004525
(87) Internationale Veröffentlichungsnummer: WO 2002/049215

(56) Entgegenhaltungen:
- WO-A-00/24105
- WO-A-94/11937
- DE-A- 3 445 340
- DE-C- 19 610 135
- US-A- 6 049 447
- HEIL H ET AL: "MINI-PROFETS IN MILLI-SMART TECHNOLOGY: HIGH-SIDE SMART POWER SWITCHES WITH ALL-ROUND PROTECTION" COMPONENTS, SIEMENS AKTIENGESELLSCHAFT. MUNCHEN, DE, Bd. 31, Nr. 4, 1996, Seiten 20-22, XP000636648 ISSN: 0945-1137

## Beschreibung

Die Erfindung betrifft eine Schalteinrichtung.

Zum Versorgen eines elektrischen Verbrauchers (Gerätes, Last) mit elektrischer Energie oder Leistung wird der Verbraucher in der Regel über ein Schaltgerät (eine Schalteinrichtung) mit einem Leitungsabzweig eines elektrisches Versorgungsnetzes verbunden.

Das vor den Verbraucher in den Leitungsabzweig geschaltete Schaltgerät ist zum Ein- und Ausschalten des elektrischen Stromes für den elektrischen Verbraucher vorgesehen. Im normalen Betrieb (Nennbetrieb) schaltet das Schaltgerät die für den elektrischen Verbraucher erforderlichen Nennströme. In besonderen Situationen, beispielsweise beim Einschalten, kann der Verbraucher deutlich höhere elektrische Leistungen benötigen und dadurch der durch das Schaltgerät fließende elektrische Strom deutlich höher als der Nennstrom liegen. Man spricht dann von einem Überlaststrom. Schließlich kann durch einen Kurzschluss im elektrischen Verbraucher oder in den zum Verbraucher führenden Leitungen der Widerstand des Verbrauchers drastisch sinken oder entfallen und dadurch der durch das Schaltgerät fließende elektrische Strom sehr hohe Werte annehmen. Diese hohen Kurzschlussströme führen zu einer hohen Verlustleistung im Schaltgerät und Verbraucher und dadurch sehr schnell zu einer Beschädigung oder Zerstörung des Schaltgerätes oder Verbrauchers. Aus diesem Grund müssen die Schaltgeräte und Verbraucher vor über einen zu langen Zeitraum fließenden Überlastströmen oder Kurzschlussströmen geschützt werden. Dazu werden spezielle Schutzgeräte eingesetzt, die zum Schutz des Verbrauchers vor zu hohen Strömen den Leitungsabzweig vom Versorgungsnetz trennen, falls ein solcher kritischer Strom auftritt. Als Schutzgeräte werden meistens Schmelzsicherungen Leitungsschutzschalter oder Leistungsschalter verwendet.

Zum Schutz vor Überlast- und Kurzschlussströmen sind Schaltgeräte wünschenswert, die selbst überlast- bzw. kurzschlusssicher sind und deshalb auch als eigensichere Schaltgeräte bezeichnet werden. Solche eigensicheren Schaltgeräte sollen sich und den Leitungsabzweig selbsttätig schützen, so dass beim Einsatz solcher Schaltgeräte im Abzweig keinerlei Schäden durch Kurzschlussströme oder Überlastströme auftreten können.

Zum Schalten elektrischer Ströme sind neben den überwiegend eingesetzten mechanischen Schaltgeräten mit Schaltkontakten auch elektronische Schaltgeräte bekannt, die mit Halbleiterbauelementen realisiert werden. Solche Halbleiterbauelemente kann man unterteilen in stromgesteuerte Halbleiterbauelemente, zu denen bipolare Transistoren und Thyristoren gehören, einerseits und spannungsgesteuerte Halbleiterbauelemente wie beispielsweise die unipolaren MOS(Metal-Oxide-Semiconductor)-Feldeffekttransistoren (MOSFET) oder die bipolaren MOS-gesteuerten Thyristoren (MCT) oder die MOS-gesteuerten bipolaren Transistoren (IGBT) andererseits. Alle genannten Halbleiterbauelemente können nur Ströme in einer Stromrichtung (Durchlassrichtung), d. h. nur bei einer bestimmten Polarität der anliegenden Betriebsspannung zwischen einem Durchlasszustand und einem Sperrzustand geschaltet werden (schaltbarer Zustand). Jedes Halbleiterbauelement kann in seinem Sperrzustand nur bis zu einer maximalen Sperrspannung (Durchbruchsspannung) sperren. Bei höheren Sperrspannungen geschieht ein Ladungsträgerdurchbruch, der schnell zur Zerstörung des Bauelements führen kann.

Aus *WO 95*/*24055 A1* ist eine elektrische Schalteinrichtung bekannt, bei der ein Halbleiterbauelement mit zwei antiseriell geschalteten FETs und an beiden Seiten des Halbleiterbauelements jeweils ein Unterbrecherkontakt in einen Leitungszug geschaltet sind. Die Unterbrecherkontakte werden von einem Auslöseglied, das parallel zum Halbleiterbauelement geschaltet ist, ein- oder ausgeschaltet. Zwischen Gate und Source der beiden FETs liegt eine Steuerspannung einer Steuereinrichtung an. Im Leitungszug ist ein Stromsensor angeordnet, mit dem die Steuereinrichtung verbunden ist. Die Steuereinrichtung prüft, wann ein zulässiger Kurzschlussstrom erreicht bzw. überschritten wird und stellt die Steuerspannung für die beiden FETs dann so ein, dass der zulässige Kurzschlussstrom nicht überschritten wird, indem der Innenwiderstand der FETs über die Steuerspannung erhöht wird. Die Steuereinrichtung erzeugt die Steuerspannung mit Hilfe einer Hilfsenergie (Fremdenergie). Das Signal des Stromsensors dient nur zur Auswertung, wann ein Kurzschlussfall vorliegt oder nicht.

Die WO 95/07571 A1 offenbart einen Wechselstromsteller mit zwei antiseriell geschalteten MOSFETs auf Basis von Siliciumcarbid. Jeder SiC-MOSFET ist über eine eigene Gate-Source-Steuerspannung ansteuerbar. Die Gate-Source-Spannung ist in Durchlassrichtung so groß eingestellt, dass sich eine gewünschte Begrenzung des Drain-Source-Stromes einstellt und im Inversbetrieb nur so groß, dass die inneren Body-Dioden der MOSFETs noch stromlos sind. Durch die Strombegrenzungseigenschaft dieser Schaltung können Kurzschlussströme auf ein akzeptables Niveau begrenzt und durch entsprechend laufend erniedrigte Gate-Source-Spannungen abgesenkt werden. Die Gate-Source-Spannungen werden mit Hilfe einer externen Energiequelle erzeugt.

Aus DE 196 10 135 C1 ist eine elektronische Schalteinrichtung bekannt, die zwei elektrische Anschlüsse zum Anlegen elektrischer Betriebsspannungen, ein Halbleiterbauelement auf Siliciumbasis (Siliciumbauelement) und zusätzlich eine Halbleiteranordnung aufweist. Die Halbleiteranordnung umfasst ein erstes Halbleitergebiet eines vorgegebenen Leitungstyps und wenigstens ein weiteres Halbleitergebiet des entgegengesetzten Leitungstyps, zwischen denen jeweils ein p-n-Übergang gebildet ist. Die Halbleitergebiete sind jeweils mit einem Halbleiter mit einer Durchbruchfeldstärke von wenigstens 10⁶ V/cm gebildet, insbesondere Diamant, Aluminiumnitrid (AIN), Galliumnitrid (GaN), Indiumnitrid (InN) und vorzugsweise Siliciumcarbid (SiC), insbesondere der Polytypen 3C, 4H und/oder 6H.

Es ist nun wenigstens ein an den p-n-Übergang angrenzendes Kanalgebiet im ersten Halbleitergebiet der Halbleiteranordnung mit dem Siliciumbauelement elektrisch in Reihe zwischen die beiden Anschlüsse geschaltet. Das Siliciumbauelement weist bei Betriebsspannungen einer vorgegebenen Polarität einen Durchlasszustand und einen Sperrzustand auf. Der p-n-Übergang der Halbleiteranordnung ist elektrisch zwischen die beiden Anschlüsse in Sperrichtung für die Betriebsspannungen geschaltet. Wenn das Siliciumbauelement in seinem Sperrzustand ist, schnürt die Verarmungszone des wenigstens einen p-n-Übergangs das Kanalgebiet im ersten Halbleitergebiet ab oder überdeckt sogar das gesamte Kanalgebiet. Dadurch fällt im Sperrzustand des Siliciumbauelements über der Verarmungszone des p-n-Übergangs bereits der größte Anteil der Betriebsspannung zwischen den beiden Anschlüssen ab. Aufgrund der hohen Durchbruchsfeldstärke von wenigstens 10⁶ V/cm des für die Halbleitergebiete des p-n-Übergangs vorgesehenen Halbleiters kann der p-n-Übergang der Halbleiteranordnung deutlich höhere Sperrspannungen tragen als ein in Silicium gebildeter p-n-Übergang mit gleichen Ladungsträgerkonzentrationen und Abmessungen. Die Durchbruchsfeldstärke von Silicium liegt zum Vergleich bei etwa 2 · 10⁵ V/cm. Das Siliciumbauelement muss deshalb nur für den übrigbleibenden Teil der Sperrspannung zwischen den beiden Anschlüssen ausgelegt werden. Dies wiederum hat eine deutlich reduzierte Verlustleistung des Siliciumbauelements im Durchlassbetrieb zur Folge. Am p-n-Übergang der Halbleiteranordnung liegt ferner im anderen Schaltungszweig die gesamte Betriebsspannung zwischen den beiden Anschlüssen als Sperrspannung an. Im Durchlasszustand des Siliciumbauelements wird das Kanalgebiet im ersten Halbleitergebiet der Halbleiteranordnung wieder geöffnet und es kann durch das Kanalgebiet nun ein elektrischer Strom zwischen den beiden Anschlüssen fließen.

Als Siliciumbauelement wird ein Leistungs-MOSFET, vorzugsweise vom Normally-off-Typ, oder auch ein MESFET (Metal-Semiconductor-Field-Effect-Transistor) vorgeschlagen. Die Halbleiteranordnung ist vorzugsweise als vertikaler JFET (Junction-Field-Effect-Transistor) ausgebildet. Die Source des JFET ist mit der Drain des Silicium-MOSFET kurzgeschlossen. Die Drain des JFET ist mit dem zweiten Anschluss der elektronischen Schalteinrichtung elektrisch verbunden. Das Gate des JFET ist mit dem ersten Anschluss der elektronischen Schalteinrichtung und der Source des Silicium-MOSFET elektrisch kurzgeschlossen. Mit einer solchen bekannten elektronischen Einrichtung, die als Hybrid-Leistungs-MOSFET oder Kaskodeschaltung bezeichenbar ist, können insbesondere Sperrspannungen bis zu 5000 V und Durchlassströme zwischen 5 A und 5000 A erreicht werden, wenn als Halbleitermaterial für die Halbleiteranordnung Siliciumcarbid (SiC) verwendet wird. Kombiniert man in einer weiteren Ausführungsform der aus DE 196 10 135 C1 bekannten elektronischen Einrichtung eine Halbleiteranordnung von einem IGBT-artigen Hybrid auf Basis von Siliciumcarbid (SiC) mit einem Silicium-MOSFET, so können Sperrspannungen von bis zu 10 000 V und Nennströme bis 100 A/Chip erreicht werden.

Die weitere Druckschrift DE 198 33 214 C1 offenbart eine als Mesa-Struktur mit Epitaxie-Schichten aufgebaute JFET-Halbleiteranordnung, vorzugsweise auf Basis von Siliciumcarbid (SiC), als Schaltelement. Diese hochsperrende JFET-Halbleiteranordnung wird besonders für Umrichteranwendungen für drehzahlveränderbare Antriebe oder als Wechselspannungsschalter von Motorabzweigen vorgeschlagen, bei denen die schaltenden Bauelemente "normally off" betrieben werden müssen, d. h. bei Stromausfall automatisch in den sperrenden Zustand übergehen sollen. Dazu wird vorgeschlagen, die hochsperrende JFET-Halbleiteranordnung in einer Kaskodeschaltung mit einem Niedervolt-MOSFET bzw. Niedervolt-Smart-MOSFET zu verschalten, wobei der Niedervolt-FET in bekannter Silicium-Technologie hergestellt werden kann.

Sowohl bei der aus DE 196 10 135 C1 bekannten als auch bei der in der DE 198 33 214 C1 beschriebenen Kaskodeschaltung ist ohne eine zusätzliche Elektronik mit Hilfsenergieversorgung eine Eigensicherheit der Schalteinrichtung nur bedingt erfüllt. Zwar können im Vergleich zu herkömmlichen Halbleiterschaltelementen auf Siliciumbasis wesentlich längere Überstrom- oder Kurzschlusszeiten erlaubt werden. Die bei einer Überlast oder einem Kurzschluss über längere Zeit aufgenommene Verlustleistung in der Halbleiteranordnung (dem JFET) der Kaskodeschaltung führt jedoch nach einigen Netzperioden (bei Wechselspannung) oder allgemein einiger Zeit des Anliegens des Überlast- oder Kurzschlussstromes dennoch zu einer thermischen Zerstörung des Schutzelements und damit Schaltelements.

In der DE 196 10 135 C1 wird zwar vorgeschlagen, den Silicium-Leistungs-MOSFET durch einen sogenannten Smart-power-Silicium-MOSFET oder ein entsprechendes intelligentes Siliciumbauelement zum Schalten zu ersetzen, um die elektronische Einrichtung ausser mit Schaltfunktionen auch mit Schutzfunktionen, wie z. B. Überspannungsschutz oder Überstromabschaltung, auszustatten. Die DE 196 101 135 C1 macht allerdings keine konkreten Angaben darüber, wie die Verschaltung in dem Smart-power-Silicium-MOSFET aussehen muss, um die genannten Schutzfunktionen, insbesondere die Überstromabschaltung, zu realisieren, insbesondere da der Sättigungsstrom des JFET im normalen ohmschen Arbeitsbereich des Silicium-MOSFET liegt und deshalb für den MOSFET kein detektierbarer Überstrom ist.

Die weitere Druckschrift DE 34 45 340 A1 offenbart einen Einrichtungs- oder Zweirichtungsschalter, der in einen Leitungsabzweig eine Netzspannung von 220 V und 50 Hz mit einer Last in Reihe geschaltet ist. Der Schalter umfasst in der Ausführung als Einrichtungsschalter einen MOSFET und einen dazu in Reihe geschalteten Widerstand (R1) und in einer Ausführung als Zweirichtungsschalter zwei antiseriell geschaltete MOSFETs mit einem zwischen die beiden FETs geschalteten Widerstand (R1). Die an dem Widerstand (R1) abfallende Spannung wird von einer Strombegrenzungsschaltung mit einem weiteren Widerstand und einem bipolaren Transistor im Falle des Einrichtungsschalters und mit zwei Widerständen und zwei bipolaren Transistoren im Falle des Zweirichtungsschalters abgegriffen. Die Strombegrenzungsschaltung ist mit dem Gate jedes MOSFET verbunden und reduziert die zwischen Gate und Source anliegende Steuerspannung am MOSFET, wenn der Spannungsabfall an dem Widerstand (R1) größer als 0,6 V wird. Die Strombegrenzungsschaltung regelt den Strom durch den Widerstand (R1) und damit durch den gesamten Schalter auf einen Wert im Gleichgewichtszustand, der einen Spannungsabfall verursacht, der der Basis-Emitter-Spannung der bipolaren Transistoren der Strombegrenzungsschaltung entspricht. Wegen des immer in Reihe liegenden Widerstandes (R1) der Strombegrenzungsschaltung weist dieser bekannte Schalter jedoch auch im Nennbetrieb hohe elektrische Verluste auf. Die Strombegrenzung geschieht über die MOSFET-Schaltelemente selbst, deren elektrischer Widerstand durch die Veränderung der Gate-Spannung durch die Strombegrenzungsschaltung gesteuert wird.

Der Schalter gemäß DE 34 45 340 A1 weist ferner einen Kurzschlussschutz auf, indem zwei zusätzliche Transistoren (FET3 und FET4) vorgesehen werden. Ein FET (FET4) bildet einen Steuerschalter, der zusammen mit einem Widerstand (R5) zwischen die beiden Pole der Steuerspannung geschaltet ist. Das Gate dieses Steuerschalter-FET ist mit der Source des anderen FET (FET3) verbunden. Die Drain dieses anderen FET wiederum ist über eine Diode (Da) mit einem Pol der Netzspannung verbunden, während sein Gate mit dem Plus-Pol der Steuerspannung verbunden ist. Wenn die Last kurzgeschlossen wird, steigt der Strom im Einschaltzustand auf den begrenzten Wert an. Wenn dieser erreicht ist, erscheint die momentane Wechselspannung über die Diode Da am Drain des zweiten FET (FET3). Die Gate-Spannung am FET3 ist bei Ansteuerung der Schaltung positiv. Das Spannungsniveau an Source von FET3 ist gleich dem des Gates von FET4 und ebenfalls positiv, so dass der FET4 leitet. Dies bewirkt, dass die Steuerspannung an dem oder den Gates der MOSFETs auf einen kritischen Wert unterhalb der thermischen Gate-Source-Spannung reduziert wird und der Schalter abschaltet.

Allerdings ist diese bekannte Schaltung im Kurzschlussfall sehr gefährdet, da der MOSFET (FET1) Kurzschlussströme nur wenige Mikrosekunden thermisch aushält und danach zerstört wird und die mit den beiden Transistoren FET3 und FET4 gebildete Abschaltung kein derart schnelles Abschalten gewährleisten kann. Gemäß der DE 34 45 340 A1 soll sowohl die Strombegrenzung als auch die Kurzschlussschutzfunktion mit Abschalten des MOSFET ohne Fremdenergie funktionieren. Das Abgreifen des Spannungsabfalls an dem Schaltelement zum Abschalten des Schaltelementes selbst ist jedoch nicht praktikabel, da der MOSFET mit einem möglichst geringen Durchlasswiderstand ausgelegt werden muss, um Schaltverluste zu minimieren, und deshalb erheblichen thermischen Belastungen ausgesetzt ist, bis die zum Abschalten erforderliche Überspannung im Kurzschlussfall erreicht ist. Dieser bekannte Schalter ist deshalb nicht eigensicher.

Die Druckschrift WO 94/11937 A1 offenbart eine Arbeitsschaltung mit einem FET als elektronischem Schaltelement und einem in Reihe geschalteten temperaturabhängigen Widerstand als elektronischem Schutzelement zum Schutz des Schaltelements vor zu hohen Joulschen Verlusten in einem Gefährdungsfall, insbesondere in einem Überlastfall oder Kurzschlussfall. Das Schutzelement trägt im Gefährdungsfall wegen der damit verbundenen Erwärmung den überwiegenden Teil der an der Arbeitsschaltung aus Schaltelement und Schutzelement abfallenden Betriebsspannung. Es sind auch Ausschaltmittel offenbart, die in dem Gefährdungsfall das Schaltelement unter Ausnutzung der in dem Betriebsstrom bzw. der Betriebsspannung enthaltenen Energie selbsttätig in den ausgeschalteten Zustand bringen, wenn der durch die Arbeitsschaltung fließende Betriebsstrom oder die an der Arbeitsschaltung oder dem Schutzelement abfallende Spannung einen vorgegebenen oberen Grenzwert überschreitet. Diese Ausschaltmittel umfassen eine Schaltung eines bipolaren Transistors, der mit dem Gate des FET-Schaltelements zu dessen Ein- oder Ausschalten verbunden ist, zusammen mit Dioden und Widerständen als Spannungsteiler.

Die WO 00/24105 A1 offenbart eine Schaltung mit einem PTC-Widerstand in Reihe zu einem MOSFET-Schaltelement oder einem JFET-Schaltelement. Der PTC-Widerstand dient als Schutzelement für das Schaltelement im Gefährdungsfall. Ein Transistor zusammen mit einem Spannungsteiler schaltet das MOSFET-Schaltelement ab, wenn die Spannung über dem PTC-Widerstand einen gewissen Wert überschreitet, also im Falle eines Fehlerstromes oder Kurzschlussstromes. Diese Ausschaltmittel arbeiten ebenfalls selbsttätig, das heißt ohne Hilfsenergie.

Der Erfindung liegt nun die Aufgabe zugrunde, eine elektronische Schalteinrichtung und ein Verfahren zum Betreiben einer Schalteinrichtung anzugeben, bei denen auch ohne Zufuhr von Hilfsenergie eine zuverlässige Eigensicherheit der Schalteinrichtung erreicht wird.

Diese Aufgabe wird gemäß der Erfindung gelöst durch eine Schaltanlage mit den Merkmalen des Anspruchs 1 bzw, ein Verfahren zum Betreiben einer Schaltanlage gemäß dem fakultativ auf Anspruch 1 rückbezogenen Anspruch 39.

Die in den Ansprüchen 1 und 39 beanspruchte Erfindung geht aus von einer Schalteinrichtung mit einer Arbeitsschaltung (Betriebsschaltung) aus wenigstens einem elektronischen und wenigstens einem, im allgemeinen zum Schaltelement elektrisch in Reihe geschalteten, elektronischen Schutzelement. An die Arbeitsschaltung ist eine Betriebsspannung anlegbar oder angelegt. Das Schaltelement ist über ein an wenigstens einen Steueranschluss anlegbares Schaltsignal zwischen einem ausgeschalteten Zustand und einem eingeschalteten Zustand hin- und herschaltbar. Das Schutzelement schützt das Schaltelement im eingeschalteten Zustand, also wenn ein Betriebsstrom durch die Schaltung aus Schutzelement und Schaltelement fließt, vor einer zu hohen thermischen Belastung in einem Gefährdungsfall, insbesondere in einem Überlastfall oder im Kurzschlussfall, bei dem durch die Arbeitsschaltung wesentlich höhere Ströme als im normalen Betrieb (Nennbetrieb) fließen oder als prospektive Ströme fließen würden und das Schaltelement durch die resultierende Joulesche Verlustwärme thermisch gefährden würden. Dazu trägt (oder: übernimmt, nimmt auf) das Schutzelement bei eingeschaltetem Schaltelement im Gefährdungsfall den überwiegenden oder wesentlichen Teil der Betriebsspannung (Spannungsabfall) und übernimmt damit auch entsprechend den überwiegenden Teil der in der Arbeitsschaltung im Gefährdungsfall auftretenden Jouleschen Verlustleistung. Das Schutzelement ist entsprechend robust ausgeführt. Eine spezielle Schaltung und Ausführung mit diesen Eigenschaften ist aus der eingangs erwähnten DE 196 101 35 C1 an sich bekannt.

Bei über einen zu langen Zeitraum fließenden hohen Strömen und somit hohen Verlustenergien (i.e. über die Zeit integrierte Verlustleistung) ist bei einer solchen Schalteinrichtung aber auch das Schutzelement thermisch gefährdet.

Die Erfindung beruht nun auf dem ersten Gedankenschritt, das Schaltelement im Gefährdungsfall bei Eintreten eines durch Überschreiten eines kritischen Strom- oder Spannungswertes (oder: oberen Grenzwertes, Schwellwertes, Maximalwertes) gekennzeichneten Abschalt- oder Ausschaltkriteriums abzuschalten und so die über dem Schutzelement abfallende Überspannung und zu große thermische Energie zu beseitigen. Zum Ausschalten wird der durch die Arbeitsschaltung fließende Betriebsstrom oder die an der gesamten Arbeitsschaltung oder dem Schutzelement abfallende Betriebsspannung herangezogen und ein entsprechender zugehöriger oberer Grenzwert.

Die Erfindung basiert ferner auf dem zweiten Gedankenschritt, die für das Abschalten des Schaltelements erforderliche Energie nicht von einer externen Fremd- oder Hilfsenergiequelle zu beziehen, sondern direkt aus der an der Arbeitsschaltung zur Verfügung stehenden elektrischen Betriebsenergie. Das-Ausschalten des Schaltelements im Gefährdungsfall gemäß der Erfindung geschieht somit völlig autark und kann nicht durch ein Ausbleiben von Hilfsenergie gefährdet werden. Die elektronische Schalteinrichtung und das Verfahren zum Betreiben einer Schalteinrichtung gemäß der Erfindung sind somit vollständig eigensicher. Die gemäß der Erfindung ausgestaltete oder betriebene Schalteinrichtung weist somit die Flexibilität elektronischer Schaltgeräte und zugleich eine Robustheit auf, die mit mechanischen Schaltgeräten vergleichbar ist.

Nun wird im Überlastfall oder Kurzschlussfall zwar das Schaltelement durch die Ausschaltmittel ausgeschaltet und damit der Stromfluss durch die Schalteinrichtung auf einen unkritischen Wert begrenzt. Jedoch sinkt nach dem Ausschalten des Schaltelements der Betriebsstrom und damit die an der Schaltung aus Schaltelement und Schutzelement abfallende Betriebsspannung wieder auf einen Wert unterhalb des zugehörigen kritischen oberen Grenzwertes ab. Damit ist die Steuergröße für die Ausschaltmittel, insbesondere den Steuerschalter, wieder im unkritischen Bereich außerhalb des Gefährdungsfallbereiches.

Die Erfindung beruht nun auf dem dritten Gedankenschritt, dass die Ausschaltmittel nach dem Ausschalten des Schaltelements im Gefährdungsfall den ausgeschalteten Zustand des Schaltelements zumindest für einen bestimmten Zeitraum (Mindestzeitintervall) selbsttätig aufrecht erhalten, insbesondere also nach dem einmaligen Abschaltvorgang keine weitere Energie mehr aus der Betriebsspannung oder dem Betriebsstrom benötigen.

Die Ausschaltmittel schalten das Schaltelement im Gefährdungsfall aus und halten anschließend das Schaltelement nur für ein vorgegebenes Zeitintervall in dem ausgeschalteten Zustand. Während dieses Zeitintervalls ist dann das von den Ausschaltmitteln gelieferte Steuersignal unabhängig von der aktuell anliegenden Betriebsspannung oder dem Betriebsstrom und entspricht dem Ausschalt-Schaltsignal für das Schaltelement. Die Ausschaltmittel halten somit den ausgeschalteten Zustand des Schaltelements für das vorgegebenes Mindestzeitintervall aufrecht, auch wenn der Gefährdungsfall nicht mehr vorliegt. Nach Ablauf des Zeitintervalls ist dagegen das Schaltsignal der Ausschaltmittel wieder abhängig von der aktuell anliegenden Betriebsspannung oder dem Betriebsstrom und geht erst wieder bei Auftreten eines erneuten Gefährdungsfalles in den Ausschaltmodus über. Das Schaltelement ist somit im Nennbetrieb wieder frei schaltbar.

Es handelt sich bei der Betriebsspannung und damit dem Betriebsstrom um eine zeitlich veränderliche, auch in der Polarität wechselnde (alternierende), Größe, also eine periodisch alternierende Spannung oder Strom (Wechselspannung bzw. Wechselstrom), wie sie üblicherweise von elektrischen Energieversorgungsnetzen oder elektrischen Generatoren bereitgestellt wird. Eine solche Wechselspannung oder ein solcher Wechselstrom hat idealerweise einen sinusförmigen zeitlichen Verlauf.

Eine alternierende Betriebsspannung hat nun den Effekt, dass im Überlast- oder Kurzschlussfall der Überlast- oder Kurzschlussstrom ebenfalls die Polarität ändert, insbesondere mit der Periode der Betriebsspannung oszilliert. Wenn also der Betriebsstrom durch die Ausschaltmittel bei Überschreiten des Grenzwertes in einer Halbperiode (Halbwelle) reduziert oder ganz abgeschaltet wird, so wird durch die Rückkopplung auf die Ansteuerung der Ausschaltmittel das Schaltelement wieder in den leitenden Zustand gebracht (eingeschaltet). Die Schaltung mit Schaltelement und Schutzelement wird deshalb elektrisch und thermisch durch die Verlustleistung bei unterhalb des Grenzwertes liegenden Strom- oder Spannungswerten in jeder Halbwelle belastet.

Dieses Wiedereinschalten des Schaltelementes während einer Phase einer Polarität, insbesondere einer Halbperiode (Halbwelle), der alternierenden Betriebsspannung wird gemäß der Erfindung verhindert durch die schon beschriebene Aufrechterhaltung des ausgeschalteten Zustandes des Schaltelementes für eine vorgegebene Mindestzeitdauer.

Die Mindestzeitdauer, während der das Schaltelement durch die Ausschaltmittel im Sperrzustand (nicht leitenden Zustand) gehalten wird, wird dazu gemäß einem vierten Gedankenschritt der Erfindung mindestens so groß wie die halbe Periodendauer der Betriebswechselspannung gewählt, um in derselben Halbperiode, in der der Gefährdungsfall.auftrat, keine oder nur noch geringe weitere Verluste zu erlauben. Vorzugsweise ist die Mindestzeitdauer für die Abschaltung des Schaltelements wenigstens so groß wie die volle Periodendauer der Betriebswechselspannung gewählt, um auch die Halbperiode mit entgegengesetzter Polarität der Betriebswechselspannung zu überbrücken.

Vorteilhafte Ausgestaltungen, Weiterbildungen und Anwendungen der Schalteinrichtung ergeben sich aus den vom Anspruch 1 abhängigen Ansprüchen.

In einer ersten Ausführungsform weisen die Ausschaltmittel der Schalteinrichtung wenigstens drei Anschlüsse auf, von denen zwei Eingänge sind und einer ein Ausgang ist. Die beiden Eingänge sind mit der Arbeitsschaltung mit Schaltelement und Schutzelement verbunden derart, dass an oder zwischen den

Eingängen die Betriebsspannung selbst oder ein über oder in der Schaltung mit Schaltelement und Schutzelement abfallender Teil der Betriebsspannung oder der durch die Schaltung fließender Betriebsstrom oder ein davon abgezweigter-Teil abgreifbar oder abgegriffen ist. Aus dieser an den Eingängen abgegriffenen elektrischen Größe, Spannung oder Strom, bilden die Ausschaltmittel nun ein Schaltsignal, das am Ausgang bereitgestellt wird und damit am Steueranschluss des Schaltelements anlegbar oder angelegt ist. Das Schaltsignal der Ausschaltmittel lässt den Zustand des Schaltelements im Normalbetrieb unberührt, solange der Gefährdungsfall nicht auftritt. Wenn der Gefährdungsfall aber eintritt, dann ändern die Ausschaltmittel mit Hilfe der in Betriebsspannung oder Betriebsstrom vorhandenen elektrischen Energie das Schaltsignal am Ausgang und schalten mit dem geänderten Schaltsignal das Schaltelement aus, bringen das Schaltelement also in den Sperrzustand oder stromlosen Zustand.

Eine besonders vorteilhafte Ausführungsform der Schalteinrichtung ist dadurch ausgezeichnet, dass die Ausschaltmittel einen Steuerschalter zum Ausschalten des Schaltelements umfassen. Der Steuerschalter wird nun zwischen den Steueranschluss des Schaltelements und einen Schaltpunkt geschaltet, an dem ein Signal anliegt, das bei Durchschalten des Steuerschalters auf den Steueranschluss des Schaltelements das Schaltelement ausschaltet, also einem Ausschaltsignal entspricht. Dieses an dem Schaltpunkt anliegende Signal kann insbesondere ein im wesentlichen konstantes elektrisches Potential, vorzugsweise Erdpotential oder Massepotential, sein. An einen Steueranschluss des Steuerschalters wird nun ein Steuersignal angelegt, das aus der Betriebsspannung oder dem Betriebsstrom erzeugt ist. Das Steuersignal schaltet den Steuerschalter ein, bringt ihn also in seinen Durchlasszustand oder eingeschalteten Zustand, wenn der Gefährdungsfall vorliegt. Umgekehrt, wenn also der Gefährdungsfall nicht vorliegt, wird der Steuerschalter über ein entsprechend geändertes Steuersignal ausgeschaltet, also in seinen Sperrzustand oder ausgeschalteten Zustand gebracht. Dies hat nun zur Folge, dass im Nennbetrieb (i.e. Normalbetrieb, kein Gefährdungsfall) das Ausschaltsignal, insbesondere das konstante Potential, am auf der anderen Seite des Steuerschalters befindlichen Schaltpunkt durch den Steuerschalter vom Steueranschluss des Schaltelements entkoppelt und damit nicht wirksam ist zur Steuerung des Schaltelements. Im Gefährdungsfall dagegen schaltet der Steuerschalter das Ausschaltsignal am Schaltpunkt, ggf. über weitere Schaltungsbausteine, auf den Steueranschluss des Schaltelements durch. Das durchgeschaltete Steuerpotential oder Schaltsignal des Schaltpunktes bewirkt nun das Übergehen des Schaltelements in dessen Sperrzustand. Das Ausschaltsignal hält nun das Schaltelement im Gefährdungsfall geschlossen (ausgeschaltet) unabhängig davon, wie weit der aktuelle Wert der Betriebsspannung oder des Betriebsstromes über dem oberen Grenzwert liegt oder lag.

Da das Steuersignal für den Steuerschalter in den meisten Fällen unterhalb der Betriebsspannung an der Betriebsschaltung liegen wird, wird die Betriebsspannung in einer bevorzugten Weiterbildung durch einen Spannungsteiler heruntergeteilt und eine erhaltene Teilspannung oder ein daraus abgeleiteter Strom als Schaltsignal verwendet. Der Spannungsteiler ist dann Bestandteil der Ausschaltmittel.

Ebenso kann auch der Betriebsstrom heruntergeteilt werden, indem in den Strompfad für den Betriebsstrom oder für einen zum Betriebsstrom in eindeutiger Beziehung stehenden Abzweigstrom (Teilstrom, Monitorstrom) ein Abgreifwiderstand geschaltet wird und das Schaltsignal aus der am Abgreifwiderstand abgegriffenen Abgreifspannung erzeugen, gegebenenfalls wieder unter Zwischenschaltung eines Spannungsteilers.

Zwischen den Steueranschluss des Schaltelements und den Schaltpunkt mit dem Ausschaltsignal ist vorzugsweise ein Entkopplungswiderstand zum Steuerschalter in Reihe geschaltet. Dieser Entkopplungswiderstand ist insbesondere Teil eines Spannungsteilers zum Teilen der Betriebsspannung oder der Abgreifspannung.

In einer besonders vorteilhaften Ausführungsform umfasst der Steuerschalter der Ausschaltmittel wenigstens einen Steuertransistor. Der Steuertransistor ist vorzugsweise ein MISFET (Metall-Insulator-Semiconductor-Field-Effect-Transistor), insbesondere ein MOSFET. Das Schaltsignal ist dann insbesondere ein Steuerpotential oder eine Steuerspannung zwischen Gate und Source. Besonders vorteilhaft ist die Verwendung eines selbstsperrenden (normally-off) MISFET oder MOSFET (Anreicherungstyp). Ein solcher selbstsperrender MISFET ist bei einer Steuerspannung von 0 V oder unterhalb einer Schwellspannung im sperrenden (ausgeschalteten) Zustand und benötigt zum Einschalten oder Übergang in den Durchlasszustand eine aktive Schalt- oder Steuerspannung, die betragsmäßig größer als 0 V ist und im allgemeinen oberhalb der Schwellspannung liegen muss. Zur Aufrechterhaltung des eingeschalteten Zustandes eines solchen selbstsperrenden MISFET ist also wegen der nie ganz zu vermeidenden Verluste immer eine gewisse Mindestenergie erforderlich. Diese Energie wird im Gefährdungsfall aus der Betriebsspannung oder dem Betriebsstrom bezögen. Wenn der Gefährdungsfall nicht mehr vorliegt, wird der selbstsperrende MISFET wieder ausgeschaltet. Der selbstsperrende MISFET ermöglicht dadurch eine automatische Rücksetzung des Schaltzustandes des Schaltelements zurück in den eingeschalteten oder schaltbaren Zustand für den Nennbetrieb.

Der Steuertransistor kann aber auch ein (stromgesteuerter) bipolarer Transistor (vom npn- oder pnp-Typ) oder ein (spannungsgesteuerter) IGBT (Insulated-Gate-Bipolar-Transistor) sein. Ferner kann als Steuerschalter auch ein anderes schaltfähiges Bauelement oder Halbleiterbauelement verwendet werden, beispielsweise ein Thyristor oder ein MCT (MOS-Controlled-Thyristor).

Wenn die Schalteinrichtung in einer vorteilhaften Anwendung in einen Leitungsabzweig eines elektrischen Versorgungsnetzes, insbesondere eines Niederspannungsnetzes (typischerweise zwischen 230 V und 690 V als Effektivwert der Betriebsspannung im Nennbetrieb) vor einen elektrischen Verbraucher geschaltet wird, so trennt die Schalteinrichtung auch den Verbraucher im Überlastfall oder Kurzschlussfall rechtzeitig von dem Netz und verhindert so Schäden am Verbraucher.

Es können die Ausschaltmittel auch deaktiviert werden, sobald der Gefährdungsfall nicht mehr vorliegt. Die Ausschaltmittel erzeugen dann unmittelbar, nachdem die Betriebsspannung oder der Betriebsstrom den oberen Grenzwert wieder unterschritten hat, kein Ausschaltsignal mehr am Steueranschluss des Schaltelements.

Die Aufrechterhaltung des ausgeschalteten Zustandes des Schaltelementes auch nach (vorübergehender) Beendigung des Gefährdungsfalles kann nun in einer Untervariante dauerhaft (permanent) und unabhängig vom weiteren Verlauf der Betriebsspannung oder des Betriebsstromes sein, beispielsweise indem als Steuerschalter ein mechanischer Schalter gewählt wird. In dieser Ausführungsform wird dann vorzugsweise ein zusätzlicher Hilfsenergieanschluss zum Wiedereinschalten (nicht zum Abschalten) des Schaltelements oder ein besonderer Eingriff an den Ausschaltmitteln erforderlich sein, damit das Schaltelement nach Behebung eines Gefährdungsfalles wieder frei schaltbar wird. Diese Ausführungsform ist für praktische Anwendungen aber nicht sehr gut geeignet.

In einer vorteilhaften Ausführungsform umfassen die Ausschaltmittel zur Aufrechterhaltung des ausgeschalteten Zustandes des Schaltelements bzw. des entsprechenden Ausschalt-Schaltsignals für das Schaltelement wenigstens einen Kondensator, der vorzugsweise zwischen den Steueranschluss des Steuerschalters und den zugehörigen Schaltpunkt (mit dem Ausschältsignal) geschaltet ist. Der Kondensator speichert die dem Betriebsstrom entnommenen Ladungen und hält dadurch eine Spannung an seinen beiden Kondensatorplatten aufrecht. Diese Kondensatorspannung wird vorzugsweise durch eine parallel zum Kondensator geschaltete Zenerdiode geeignet geklemmt. Die Zenerdiode ist insbesondere zwischen den Steueranschluss des Steuerschalters und den zugehörigen Schaltpunkt geschaltet und dient zur Einstellung der Steuerspannung, auch wenn kein Kondensator vorhanden ist. In einer bevorzugten Weiterbildung ist dem Kondensator ein Entladewiderstand parallel geschaltet. Das Mindestzeitintervall für die Aufrechterhaltung des Ausschaltsignäls am Steueranschluss des Schaltelements ist nun durch die Entladungszeit (Zeitkonstante) der aus Kondensator und Entladewiderstarid gebildeten Parallelschaltung bestimmt.

Um eine Schalteinrichtung zu realisieren, die Betriebsspannungen wechselnder Polarität, insbesondere (periodische) Wechselspannungen, eigensicher schalten kann, werden zwei im allgemeinen gleiche Schaltungen aus jeweils einem Schaltelement und einem Schutzelement antiseriell in den Strompfad geschaltet und jeweils mit zugehörigen Abschaltmitteln versehen. Außerdem können auch zum Schutz der Arbeitsschaltung bei entgegengesetzter Polarität der Betriebsspannung Schutzmittel wie beispielsweise eine parallel geschaltete Schutzdiode vorgesehen sein.

Die Arbeitsschaltung aus Schaltelement und Schutzelement weist im allgemeinen einen ersten Anschluss und einen zweiten Anschluss auf. An den beiden Anschlüsse ist dann die Betriebsspannung anzulegen. Ein erster der beiden Anschlüsse der Arbeitsschaltung ist nun vorteilhafterweise mit dem dem Steuerschalter zugeordneten Schaltpunkt verbunden und liegt vorzugsweise auf gleichem elektrischen Potential wie dieser Schaltpunkt. Die aktive Phase der Betriebsspannung liegt folglich am anderen, zweiten Anschluss an.

Der Steueranschluss des Steuerschalters kann nun mit dem zweiten Anschluss für die Betriebsspannung verbunden sein. Vorzugsweise umfassen die Ausschaltmittel dann zwischen dem Steuerschalter und dem zweiten Anschluss einen zusätzlichen spannungsfesten Schalter, beispielsweise ebenfalls einen MISFET oder MOSFET, um die Ausschaltmittel im Bedarfsfall deaktivieren zu können und zusätzliche Verluste in den Ausschaltmitteln zu vermeiden, wenn das Schaltelement im ausgeschalteten Zustand ist.

Für den Nennbetrieb der Schalteinrichtung sind in der Regel Steuermittel vorgesehen, die mit dem Steueranschluss des Schaltelements, insbesondere über einen Eingangswiderstand, verbunden oder verbindbar sind und im Nennbetrieb ein Schaltsignal zum Ein- oder Ausschalten des Schaltelements an dessen Steueranschluss anlegen. Die nun zunächst bestehende Konkurrenz zwischen der Ansteuerung des Schaltelements durch die Steuermittel einerseits und die Ausschaltmittel andererseits wird vorzugsweise so aufgelöst, dass die Steuermittel den Schaltzustand des Schaltelements bestimmen, wenn nicht der Gefährdungsfall vorliegt, und die Ausschaltmittel den Schaltzustand des Schaltelements bestimmen, wenn der Gefährdungsfall eintritt. Dazu aktivieren und/oder deaktivieren die Steuermittel und die Ausschaltmittel sich vorzugsweise jeweils im entsprechenden Fall gegenseitig.

Eine Aktivierung der Ausschaltmittel durch die Steuermittel kann so realisiert sein, dass ein Steueranschluss des spannungsfesten Schalters mit den Steuermitteln verbunden ist und die Steuermittel den spannungsfesten Schalter einschalten. Dadurch schaltet der spannungsfeste Schalter durch und das Steuersignal am Schaltanschluss des Steuerschalters ist mit der Betriebsspannung oder dem Betriebsstrom an bzw. in der Arbeitsschaltung gekoppelt.

In einer besonders vorteilhaften Ausführungsform schalten die Steuermittel den spannungsfesten Schalter gemeinsam (zeitgleich, synchron) mit dem Schaltelement ein. Dadurch werden die Ausschaltmittel von den Steuermitteln nur dann aktiviert, wenn das Schaltelement im eingeschalteten Zustand ist. Ist das Schaltelement dagegen bereits von den Steuermitteln ausgeschaltet, so müssen die Ausschaltmittel nicht mehr aktiviert werden und die durch die Zusatzbeschaltung der Ausschaltmittel verursachten Verluste können vermieden werden.

Um ein negatives Ansteuern während der entgegengesetzten Polarität der Betriebswechselspannung zu vermeiden, kann zwischen den Steueranschluss des Steuerschalters und den zweiten Anschluss für die Betriebsspannung zusätzlich eine Diode geschaltet sein. Außerdem wird zur Einstellung des Signalpegels an dem Schaltanschluss des Steuerschalters zwischen den Steueranschluss des Steuerschalters und den zweiten Anschluss für die Betriebsspannung noch vorzugsweise ein Zwischenwiderstand geschaltet.

In einer besonderen Ausführungsform umfasst das Schaltelement einen unter dem Handelsnamen HITFET bekannten besonderen, von einem MISFET abgeleiteten Feldeffekttransistor, der einen zusätzlichen Strommonitorausgang umfasst. Die Ausschaltmittel greifen nun an dem Strommonitorausgang des HITFET den Betriebsstrom oder ein vom Betriebsstrom eindeutig abhängendes Stromsignal zum Erzeugen des Schaltsignals, das an den Steueranschluss des HITFET angelegt oder anlegbar ist, ab, vorzugsweise über einen Abgreifwiderstand.

In allen Ausführungsformen ist das elektronische Schutzelement auf Basis wenigstens eines Halbleiters gebildet, der eine Durchbruchsfeldstärke von wenigstens 10⁶ V/cm und/oder einen Bandabstand von wenigstens 2 eV umfasst und somit zum Sperren höherer Spannungen geeignet ist. Dadurch kann das Schutzelement einen besonders hohen Anteil der Betriebsspannung im Gefährdungsfall tragen. Geeignete Halbleitermaterialien sind Siliciumcarbid (SiC), insbesondere vom β-Polytyp (3C)-, oder von einem α-Polytyp, beispielsweise 15R-, 4H- oder 6H-Polytyp, Galliumnitrid (GaN), Diamant, Aluminiumnitrid (AlN) und Indiumnitrid (InN). Das bevorzugte Halbleitermaterial ist Siliciumcarbid (SiC) wegen seiner hohen Durchbruchsfestigkeit, geringen Verlustleistung, hohen Temperaturbeständigkeit, chemischen Resistenz und hohen Wärmeleitfähigkeit.

Für das Schaltelement steht dagegen ein möglichst gutes Schaltverhalten im Vordergrund und weniger die Spannungsfestigkeit, die vom Schutzelement weitgehend übernommen wird. Das elektronische Schaltelement ist deshalb vorzugsweise auf Basis eines oder mehrerer Halbleiter aus der Silicium (Si), Galliumarsenid (GaAs) und Germanium (Ge) umfassenden Gruppe von Halbleitern aufgebaut.

Das Schutzelement soll nun zwar im Gefährdungsfall einen (möglichst) großen Anteil der an der Arbeitsschaltung abfallenden Betriebsspannung und entsprechend der Joulschen Verluste aufnehmen, beispielsweise wenigstens 70 % und vorzugsweise wenigstens 90 %, jedoch umgekehrt im Normalbetrieb (Nennbetrieb), also bei normal betriebenem Verbraucher ohne Überlast und Kurzschluss und damit bei deutlich geringeren Nennströmen, möglichst geringe Durchlassverluste haben. Das Verhältnis aus der am Schutzelement abfallenden Spannung und der am Schaltelement abfallende Spannung und somit auch das Verhältnis aus der im Schutzelement freiwerdenden Jouleschen Verlustleistung und der im Schaltelement freiwerdenden Jouleschen Verlustleistung muss im Nennbetrieb deutlich kleiner sein als im Gefährdungsfall. Vorzugsweise nimmt deshalb der Anteil des vom Schutzelement übernommenen Spannungsabfalles und damit der Jouleschen Wärmeleistung im Gefährdungsfall gegenüber dem Nennbetrieb entsprechend stark zu. Es kann dann auch der absolute Wert des am Schaltelements abfallenden Teils der Betriebsspannung unterhalb eines vorgegebenen Maximalwertes, beispielsweise 100 V oder auch 50 V, gehalten werden. Eine solche im Gefährdungsfall relativ zur Spannungsaufnahme am Schaltelement ansteigende Spannungsaufnahme am Schutzelement kann mit einem entsprechend stromlimitierenden Bauelement erreicht werden.

Besonders geeignet ist ein Bauelement, das ein Sättigungsverhalten zeigt, bei dem also in der Strom-Spannungs-Kennlinie im Durchlassbereich der Strom sich bei steigender Spannung einem Sättigungsstrom nähert oder diesen annimmt. Der für den Eintritt des Gefährdungsfalles maßgebliche oder diesen definierende obere Grenzwert für Spannung oder Strom in der Arbeitsschaltung liegt vorzugsweise innerhalb des Bereiches, in dem das Schutzelement in Sättigung geht oder gegangen ist. Das Schutzelement hat in seiner Sättigung eine sehr flache Strom-Spannungs-Kennlinie. Die Empfindlichkeit bei der Spannungserfassung ist dann wesentlich höher als bei der Stromerfassung, so dass hier die Überwachung des Spannungsabfalls über dem Schutzelement oder der Arbeitsschaltung mit Schutzelement und Schaltelement besonders effektiv ist. Der Sättigungsstrom des Schutzelements ist vorzugsweise kleiner, beispielsweise um einen Faktor von wenigstens 2 oder sogar wenigstens 3, als der thermische Grenzstrom des Schaltelements. Der thermische Grenzstrom ist der maximal zulässige Strom, bei dem noch keine thermische Zerstörung stattfindet.

Das Schutzelement kann die anliegende Sperrspannung über wenigstens einen in Sperrichtung betriebenen p-n-Übergang und/oder wenigstens einen Schottky-Übergang tragen, bei denen jeweils die Bildung von Verarmungszonen zum Sperren der Spannung charakteristisch ist.

Bevorzugte Bauelementstrukturen für das Schutzelement und/oder das Schaltelement sind JFET (Junction-Field-Effect-Transistor)-, MESFET (Metall-Semiconductor-Field-Effect-Transistor)- und/oder MISFET-, insbesondere MOSFET-, Strukturen.

In einer besonders vorteilhaften Kombination ist das Schutzelement mit einer JFET-Struktur oder einer MESFET-Struktur und das Schaltelement mit einer MISFET-Struktur ausgestattet. Es sind dann in der als Kaskodeschaltung bezeichenbaren Arbeitsschaltung der Gateanschluss der JFET-Struktur oder MESFET-Struktur des Schutzelements mit dem Sourceanschluss der MISFET-Struktur des Schaltelements verbunden und der Sourceanschluss der JFET-Struktur oder MESFET-Struktur des Schutzelements mit dem Drainanschluss der MISFET-Struktur des Schaltelements verbunden.

Die Schalteinrichtung ist in einer vorteilhaften Anwendung in einen Leitüngsabzweig, insbesondere einen Leitungsabzweig eines elektrischen Versorgungsnetzes, vor einen elektrischen Verbraucher geschaltet.

Zur weiteren Erläuterung der Erfindung wird auf die Zeichnung Bezug genommen, in deren
- FIG 1: eine Ausführungsform einer Schalteinrichtung mit einer spannungsabhängigen Abschaltung in einer Prinzipskizze,
- FIG 2: eine Ausführungsform einer Schalteinrichtung mit einer stromabhängigen Abschaltung in einer Prinzipskizze,
- FIG 3: eine spezielle Ausführungsform einer Schalteinrichtung mit einer spannungsabhängigen Abschaltung mittels einer Transistorschaltung und
- FIG 4: eine spezielle Ausführungsform einer Schalteinrichtung mit einer stromabhängigen Abschaltung mittels einer Transistorschaltung und einem HITFET als Schaltelement
jeweils schematisch dargestellt sind. Einander entsprechende Teile sind in den FIG 1 bis 4 mit denselben Bezugszeichen versehen.

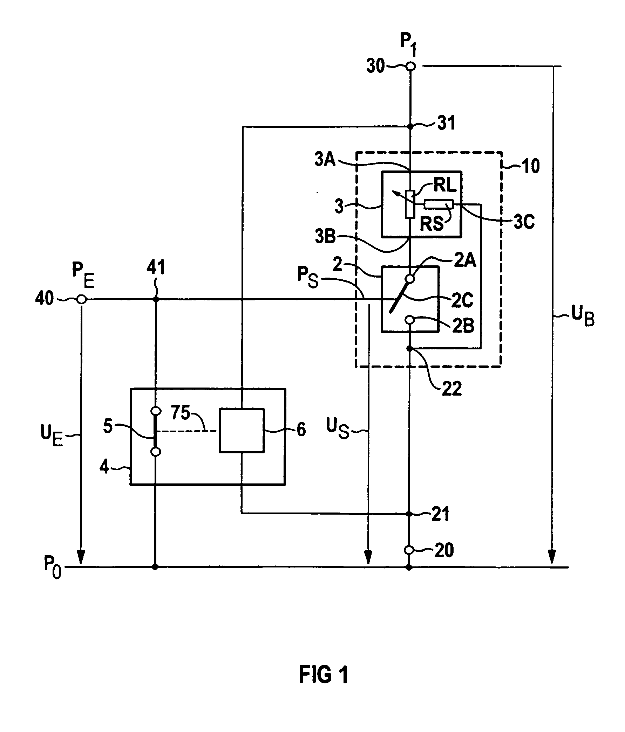

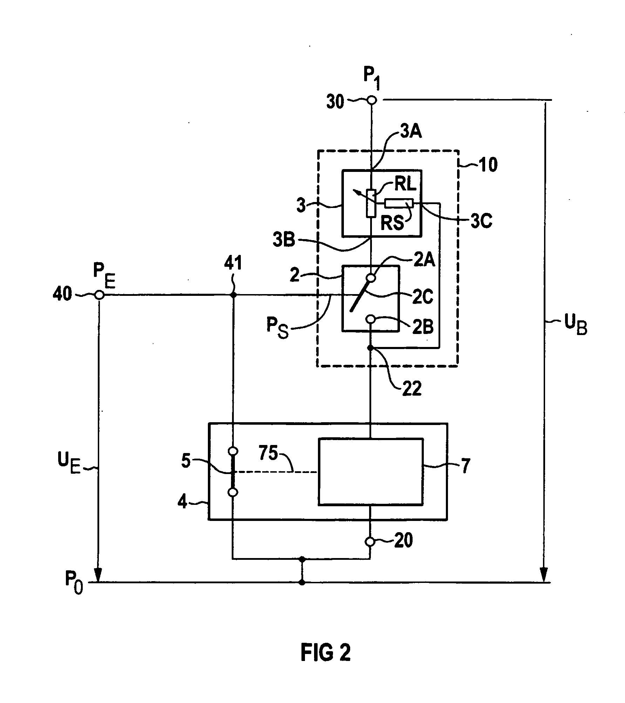

Die Schalteinrichtungen gemäß FIG 1 und 2 umfassen jeweils eine Arbeitsschaltung 10 aus einem elektronischen Schaltelement 2 mit drei elektrischen Anschlüssen (Kontakten, Elektroden) 2A, 2B und 2C und einem elektronischen Schutzelement 3 mit drei elektrischen Anschlüssen 3A, 3B und 3C. Die gesamte Arbeitsschaltung 10 ist zwischen zwei elektrische Anschlüsse 20 und 30 geschaltet, zwischen denen eine Betriebsspannung U_{B} anliegt oder anlegbar ist. Der erste Anschluss 20 liegt dabei auf einem Potential P₀ und der zweite Anschluss auf einem Potential P₁. Das Potential P₀ ist im allgemeinen im wesentlichen konstant, insbesondere Erd- oder Massenpotential, während das Potential P₁ der aktiven Phase entspricht. In einen Strompfad zwischen den beiden Anschlüssen 20 und 30 sind das Schaltelement 2 und das Schutzelement 3 elektrisch in Reihe geschaltet, indem der Anschluss 2B des Schaltelements 2 mit dem Anschluss 20 verbunden ist, der Anschluss 2A des Schaltelements 2 mit dem Anschluss 3B des Schutzelements 3 und der Anschluss 3A des Schutzelements 3 mit dem Anschluss 30.

Über den dritten Anschluss 3C des Schutzelements 3 ist das Schutzelement 3 ferner in einen zweiten, parallel zum ersten Strompfad verlaufenden Strompfad zwischen die Anschlüsse 20 und 30 geschaltet, indem der Anschluss 3C über einen Schaltpunkt 22 mit dem Anschluss 2B des Schaltelementes 2 verbunden ist.

Das elektronische Schaltelement 2 ist mit einem Schaltersymbol dargestellt und mittels eines an dem Steueranschluss 2C anliegenden Schaltsignals zwischen einem Durchlasszustand (eingeschalteter Zustand, leitender Zustand, Zustand mit niedrigem Durchlasswiderstand) und einem Sperrzustand (ausgeschalteter Zustand, nicht-leitender Zustand, Zustand mit sehr hohem Durchlasswiderstand) hin und her schaltbar ist. Im Durchlasszustand kann zwischen den beiden Anschlüssen 2A und 2B ein elektrischer Strom (Durchlassstrom) durch das Schaltelement 2 fließen. Im Sperrzustand dagegen fließt nur noch ein praktisch vernachlässigbarer Sperrstrom. Das dem Durchlasszustand des Schaltelements entsprechende Schaltsignal P_{S} wird im folgenden auch als Einschalt-Schaltsignal und das dem Sperrzustand des Schaltelements entsprechende Schaltsignal P_{S} auch als Ausschalt-Schaltsignal bezeichnet. Das Schaltsignal P_{S} ist abhängig vom Bauelement des Schaltelements 2 ein elektrisches Steuerpotential oder auch ein elektrischer Steuerstrom, kann aber auch bei optischer Ansteuerung ein Lichtsignal sein. Im allgemeinen ist das Schaltelement 2 ein Halbleiterbauelement auf Basis von Silicium (Si), insbesondere ein MOSFET, MESFET, Thyristor, IGBT oder MCT.

Das Schutzelement 3 hat die Aufgabe, das Schaltelement 2 vor zu hohen Spannungen und Strömen zu schützen. Insbesondere hat das Schutzelement 3 das Schaltelement 2 sowohl in dessen Durchlasszustand als auch in dessen Sperrzustand zumindest überwiegend gegen die anliegende Betriebsspannung U_{B} zu entlasten, so dass das Schaltelement nur für eine vorgegebene maximale Sperrspannung ausgelegt werden muss, die deutlich niedriger als die maximale Betriebsspannung ist. Im Durchlasszustand des Schaltelements 2 soll das Schutzelement 3 im Nennbetrieb möglichst geringe Durchlassverluste, also einen möglichst geringen elektrischen Widerstand, haben. Darüber hinaus soll das Schutzelement 3 im Durchlasszustand des Schaltelements 2 durch die Arbeitsschaltung 10 fließende Überlastströme, die üblicherweise wenigstens das Dreifache oberhalb der Nennströme liegen, oder die noch wesentlich höher ansteigenden Kurzschlussströme begrenzen, so dass das Schaltelement 2 nicht durch diese zu hohen Ströme zu hohen Verlustleistungen und damit der Gefahr einer thermischen Zerstörung ausgesetzt ist. Der elektrische Widerstand im Schutzelement 3 muss deshalb bei Überlastströmen und erst recht bei Kurzschlussströmen deutlich höher sein als bei Nennströmen, damit das Schutzelement 3 die hohen Ströme wirkungsvoll begrenzen kann. Das wiederum bedeutet, dass das Schutzelement 3 im Überlast- oder Kurzschlussfall entsprechend hohe Spannungsabfälle aufnimmt. Die schaltungstechnische Realisierung dieser Funktionen des Schutzelements 3 ist durch einen steuerbaren Widerstand R_{L} in Reihe zum Schaltelement 2 und einen sehr hohen Widerstand R_{S} (oder auch eine Kapazität) parallel zum Schaltelement 2 angedeutet. Wenn sich die Kennlinien von Schutzelement und Schaltelement im ohmschen Bereich befinden, entspricht das Verhältnis der Spannungsabfälle an den beiden Elementen auch dem Verhältnis ihrer jeweiligen elektrischen Widerstände. Das Verhältnis aus dem am Schutzelement abfallenden Teil der Betriebsspannung und dem am Schaltelement abfallenden Teil der Betriebsspannung im eingeschalteten Zustand des Schaltelementes, also bei Stromfluss, ist im Gefährdungsfall im allgemeinen größer als 7 : 3, insbesondere größer als 9 : 1 und vorzugsweise sogar größer als 10 : 1.

In der Praxis kann ein Halbleiterbauelement als Schutzelement 3 verwendet werden, das bei Überlastströmen oder spätestens bei Kurzschlussströmen in Sättigung, also in einem Bereich der Kennlinie mit einem mit zunehmender Spannung praktisch nicht mehr zunehmenden Strom und damit einem sehr hohen elektrischen Widerstand, ist und im Nennbetrieb im allgemeinen in einem ohmschen Bereich der Kennlinie mit geringem Widerstand ist. Beispiele für solche Bauelemente sind Feldeffekttransistoren, insbesondere JFETs, MESFETs und MOSFETs, oder IGBTs.

Das Schutzelement 3 ist aufgrund seiner genannten Eigenschaften spannungsfester ausgebildet als das Schaltelement 2 und dazu vorzugsweise mit einem Halbleitermaterial mit einem hohen Bandabstand von wenigstens 2 eV oder einer hohen Durchbruchsfeldstärke von wenigstens 1.000.000 V/cm gebildet. Das bevorzugte Halbleitermaterial für das Schutzelement 3 ist, im allgemeinen einkristallines, Siliciumcarbid (SiC), insbesondere eines oder mehrerer vorgegebener Polytypen wie dem β-Polytyp (3C-Polytyp) oder einem z. B. α-Polytyp (4H-, 6H- oder 15R-Polytyp).

Legt man an den Steueranschluss 2C des Schaltelements 2 ein Einschalt-Schaltsignal P_{S} an, so sind das Schaltelement 2 als auch das Schutzelement 3 jeweils im Durchlasszustand, so dass durch die Arbeitsschaltung 10 ein Betriebsstrom fließen kann. Dieser Betriebsstrom ist im störungsfreien Betrieb bei Normallast im Nennstrombereich. Das Schutzelement 3 ist nicht in Sättigung.

Im Falle einer Überlast oder eines Kurzschlusses geht nun das Schutzelement 3 in Sättigung und begrenzt den Strom auf den Sättigungsstrom. Hält dieser Überlastfall oder Kurzschlussfall über längere Zeit an, so tritt im Schutzelement 3 eine erhebliche Verlustwärme (Joulesche Wärme) auf, die auch das an sich robuste Schutzelement 3 beschädigen oder zerstören kann.

Aus diesem Grund sind gemäß der Erfindung Ausschaltmittel (Abschalteinrichtung) 4 vorgesehen, die in einem Gefährdungsfall wie einem Überlast- oder einem Kurzschlussfall das Schaltelement 2 ausschalten und dadurch den Stromfluss durch die Reihenschaltung 10 auf den Sperrstrom begrenzen. Das Schutzelement 3 wird dadurch wieder entlastet.

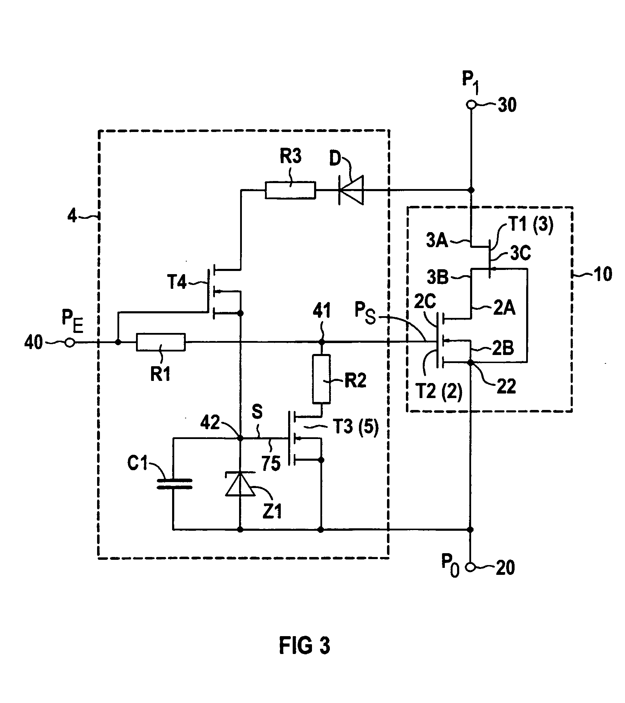

Die FIG 3 zeigt eine konkrete Ausführungsform der Arbeitsschaltung 10, die als Kaskodeschaltung aus einem mit T1 bezeichneten JFET als Schutzelement 3 und einem mit T2 bezeichneten MOSFET als Schaltelement 2 ausgebildet ist. Diese Kaskodeschaltung ist an sich bekannt und beispielsweise in der DE 196 10 135 C1 beschrieben. Ausführungsbeispiele für den JFET T1 als Schutzelement 3 sind außer in dieser DE 196 10 135 C1 auch in der DE 198 33 214 C1 beschrieben.

Der JFET T1 ist auf Basis von Siliciumcarbid (SiC) gebildet, der MOSFET T2 auf Basis von Silicium (Si). Die Source 2B des MOSFET T2 ist mit dem Anschluss 20, die Drain 2A des MOSFET mit der Source 3B des JFET T1, die Source 3A des JFET T1 mit dem Anschluss 30, das Gate 3C des JFET T1 mit der Source 2B des MOSFET T2 und dem Anschluss 20 verbunden. Zum Schalten des MOSFET T2 ist an dessen Gate 2C ein Steuerpotential P_{S} angelegt. Die Gate-Source-Spannung des MOSFET T2 ist die entsprechende Steuerspannung U_{S} = P_{S} - P₀. Dieses Steuerpotential P_{S} entspricht im Nennbetrieb dem über einen Eingangswiderstand R1 anliegenden Eingangspotential P_{E} (oder der Eingangsspannung U_{E} = P_{E} - P₀ an einem Steuereingang 40. Der MOSFET T2 ist vom selbstsperrenden Typ (Normally-off-Typ), so dass bei einer Steuerspannung Uₛ = 0 V der MOSFET T2 im ausgeschalteten Zustand ist und erst bei einer Steuerspannung Uₛ, die größer als ein bestimmter Schwellwert liegt, der MOSFET T2 aufgesteuert wird und in seinen leitenden oder eingeschalteten Zustand übergeht.

Das Verhalten des Schutzelements 3, also des JFET T1, bei Anliegen einer Betriebsdurchlassspannung ist abhängig von dem durch den JFET T1 fließenden elektrischen Betriebsstrom. Bei Erreichen eines bestimmten kritischen Stromwertes (Sättigungsstrom) geht der JFET T1 durch Abschnürung des Kanalgebietes in Sättigung und reduziert bei gleichbleibender oder auch weiter steigender Spannung den Strom unter den Sättigungsstromwert.

Falls nun im Gefährdungsfall, beispielsweise im Überlast- oder Kurzschlussfall, die Spannung am JFET T1 weiter steigt, nachdem der Strom bereits den Sättigungsstromwert erreicht hat, steigt die elektrische Verlustleistung im JFET T1, und der JFET T1 erwärmt sich weiter. Mit der steigenden internen Temperatur nimmt nun die Beweglichkeit derjenigen Ladungsträger, die durch das Kanalgebiet des JFET T1 fließen, ab. Aufgrund dieses Rückkopplungseffektes begrenzt der JFET T1 auch einen stark anwachsenden elektrischen Strom wie im Kurzschlussfall schnell auf einen unkritischen Stromwert (Begrenzungsstrom), der deutlich unter dem Sättigungsstrom im kalten Zustand liegt. Allerdings kann der JFET T1 diese Begrenzung des Überlast- oder Kurzschlussstromes nur für eine bestimmte Zeitdauer aufrechterhalten, wegen der hohen Verlustleistung. Bei über mehrere Spannungsperioden anhaltenden Kurzschlussströmen ist die Arbeitsschaltung 10 deshalb nicht zuverlässig eigensicher.

Für den Gefährdungsfall ist deshalb eine spezielle Zusatzbeschaltung als Ausschaltmittel 4 vorgesehen. Diese Zusatzbeschaltung der Ausschaltmittel 4 ist parallel zur Arbeitsschaltung 10 zwischen die beiden Anschlüsse 20 und 30 geschaltet.

Die Ausschaltmittel 4 umfassen einen Steuertransistor T3 als Steuerschalter 5. Der Steuertransistor T3 ist ebenfalls ein selbstsperrender MOSFET, insbesondere ein handelsüblicher Silicium-MOSFET. Die Source des Steuertransistors T3 ist mit dem Anschluss 20 verbunden. Die Drain des Steuertransistors T3 ist über einen Entkopplungswiderstand R2 auf einen Schaltpunkt 41 geschaltet, der zwischen dem Eingangswiderstand R1 für das Eingangspotential P_{E} und dem Gate 2C des MOSFET T2 liegt. Zwischen Source der Steuertransistors T3 und Gate des Steuertransistors T3 ist eine Parallelschaltung aus einer Zenerdiode Z1 und einem Kondensator C1 geschaltet. Das Gate des Steuertransistors T3, die Zenerdiode Z1 und der Kondensator C1 sind sternförmig auf einen Schaltpunkt 42 geschaltet, an dem sternförmig zusätzlich ein spannungsfester, weiterer Transistor T4, der vorzugsweise wieder als Normally-off-MOSFET ausgebildet ist, mit seiner Source geschaltet ist. Zwischen dem Drain dieses Transistors T4 und dem zweiten Anschluss 30 der Arbeitsschaltung 10 ist eine Reihenschaltung aus einem Zwischenwiderstand R3 und einer Diode D geschaltet. An dem Gate des Transistors T4 liegt ferner unmittelbar das Eingangspotential P_{E} des Steuereingangs 40 an.

Die Signalhöhe des am Gate des Steuertransistors T3 anliegenden Steuersignals S ist nun abhängig von der zwischen den Anschlüssen 20 und 30 anliegenden Betriebsspannung. Durch die Wahl des Widerstandswertes des Zwischenwiderstandes R3 und der Zenerspannung der Zenerdiode Z1 ist eine Schwellspannung oder ein Grenzwert für das Steuersignal S festgelegt, der einem bestimmten Grenzwert der Betriebsspannung zwischen den Anschlüssen 20 und 30 eindeutig entspricht. Solange die Betriebsspannung unter ihrem Grenzwert bleibt, bleibt der Steuertransistor T3 in seinem Sperrzustand und das Schaltsignal P_{S} am Gate 2C des MOSFET T2 ist durch das Eingangspotential P_{E} am Steuereingang 40 bestimmt. In diesem Nennbetriebsfall kann also über den Steuereingang 40 das Schaltelement 2 und damit die Arbeitsschaltung 10 in einer gewünschten Weise ein- oder ausgeschaltet werden.

Falls nun jedoch in einem Gefährdungsfall die Betriebsspannung zwischen den Anschlüssen 20 und 30 den vorgegebenen Grenzwert überschreitet, so nimmt das Steuersignal S am Gate des Steuertransistors T3 einen über dessen Schwellspannung liegenden Wert an und der Steuertransistor T3 wird durchgeschaltet. Dadurch liegt nun das Gate 2C des MOSFET T2 über den Schaltpunkt 41, den Entkopplungswiderstand R2 und den durchgeschalteten Steuertransistor T3 an dem auf dem Potential P₀ (Sourcepotential) liegenden Anschluss 20 an. Die Steuerspannung U_{S} am Gate 2C des MOSFET T2 wird somit auf einen Wert unterhalb der Schwellspannung herabgesetzt, so dass der MOSFET T2 abgeschaltet wird. Dadurch geht die gesamte Arbeitsschaltung 10 in den sperrenden, nicht leitenden Zustand über.

Somit wird über die Ausschaltmittel 4 die Kaskodeschaltung oder Arbeitsschaltung 10 bei einem Auftreten eines Überlast- oder Kurzschlussfalles selbsttätig abgeschaltet. Die Widerstände R1 und R2 dienen zur Entkopplung von der Ansteuerung für die Arbeitsschaltung 10 am Steuereingang 40. Die Diode D verhindert ein negatives Ansteuern während der entsprechenden Polarität der Spannung an der Arbeitsschaltung 10.

Bei Unterschreiten der kritischen Spannung an der Zenerdiode Z1, was einem "Nulldurchgang" der zwischen den Anschlüssen 20 und 30 anliegenden Betriebsspannung (Netzspannung) U_{B} entspricht, wird der durch den Steuertransistor T3 über das Schaltelement 2, den MOSFET T2, hervorgerufene Sperrzustand des JFET T1 aufgehoben, wodurch eine Wiedereinschaltung verursacht wird. Liegt der Kurzschluss- oder Überlastfall nicht mehr vor, dann fällt die wiederkehrende Netzspannung U_{B} am Verbraucher bzw. am abgangseitigen Leerlauf ab. Hierdurch bleibt das Schutzelement 3, das mit dem JFET T1 gebildet ist, weiterhin leitfähig. Liegt hingegen der Überlast- oder Kurzschlussfall noch vor, dann wird nach dem oben beschriebenen Wirkungsmechanismus wieder eine Spannung an der Arbeitsschaltung 10 abfallen und wieder erfindungsgemäß eine Sperrung des JFETs T1 (Schutzelement 3) vorgenommen.

Der Grenzwert der Betriebsspannung U_{B}, bei der der Steuertransistor T3 durchgeschaltet wird, liegt vorzugsweise im Bereich der Sättigung des JFET T1, der das Schutzelement 3 bildet. Nach dem Erreichen des Sättigungsstromes im Überlast- oder Kurzschlussfall in der Arbeitsschaltung 10 erfolgt ein schneller Anstieg des Spannungsabfalls an der Arbeitsschaltung 10 bis zu einer durch zusätzliche Beschaltung oder Avalanche-Effekt bestimmten Spannungshöhe. Dieser Spannungsabfall an der Arbeitsschaltung (Kaskode) 10 wird ausgenutzt, um den vorgeschalteten Steuertransistor T3 aufzusteuern und dadurch ein Abschalten des Silicium-MOSFET T2 und damit des JFET (SiC-Transistors) T1 herbeizuführen. Durch diese Abschaltung wird der durch die Transistoren T1 und T2 der Arbeitsschaltung 10 fließende Reststrom so beschränkt, dass eine thermische Zerstörung des JFET (SiC-Transistors) T1 vermieden wird.

Die Zusatzbeschaltung der Ausschaltmittel 4 sollte nur im eingeschalteten Zustand des Schaltelements 2, also bei einem Schaltsignal U_{S} > 0 V an dessen Steuerelektrode, aktiv sein, um eventuelle Verluste im Sperrfall zu minimieren. Dazu dient der in den Zusatzzweig der Ausschaltmittel 4 eingebaute als spannungsfester Schalter wirkende Transistor T4, der zusammen mit dem MOSFET T2 der Arbeitsschaltung 10 von dem Eingangspotential P_{E} (der Eingangsspannung U_{E}) aktiviert wird.

Durch die Erweiterung des Spannungsteilers in den Ausschaltmitteln 4 durch den Kondensator C1, dessen Spannung durch die Zenerdiode Z1 geklemmt ist, bleibt auch bei abnehmender Drainspannung an der Arbeitsschaltung 10 die Steuerspannung U_{S} für das Schaltelement 2, den MOSFET T2, erhalten und die Arbeitsschaltung 10 schaltet sich bei abnehmender Netzspannung nicht mehr automatisch ein. Wird in einer nicht dargestellten Ausführungsform dem Kondensator C1 noch ein geeigneter Entladewiderstand parallel geschaltet, so kann der Sperrzustand des Transistors T1 entsprechend der Zeitkonstante der Entladung nach dem Verschwinden des Kurzschlusses oder Überlastfalles wieder aufgehoben werden.

In der Ausführungsform gemäß FIG 3 wird also zum Ausschalten des MOSFET T2 und damit der Arbeitsschaltung 10 im Gefährdungsfall die an der Arbeitsschaltung 10 abfallende Betriebsspannung überwacht und aus dieser Betriebsspannung bei Überschreiten des vorgegebenen Grenzwertes das Schaltsignal Uₛ = 0 V am MOSFET T2 erzeugt. Die zum Durchschalten des Steuertransistors T3 erforderliche Energie an dessen Gate, also die zum Erhöhen des Steuersignals S am Gate des Steuertransistors T3 erforderliche Energie, wird allein aus der Betriebsspannung zwischen den Anschlüssen 20 und 30 bezogen. Eine Fremdenergie ist deshalb nicht erforderlich. Die gesamte Schalteinrichtung aus Arbeitsschaltung 10 und Ausschaltmitteln 4 sowie dem Steuereingang 40 ist somit eigensicher.

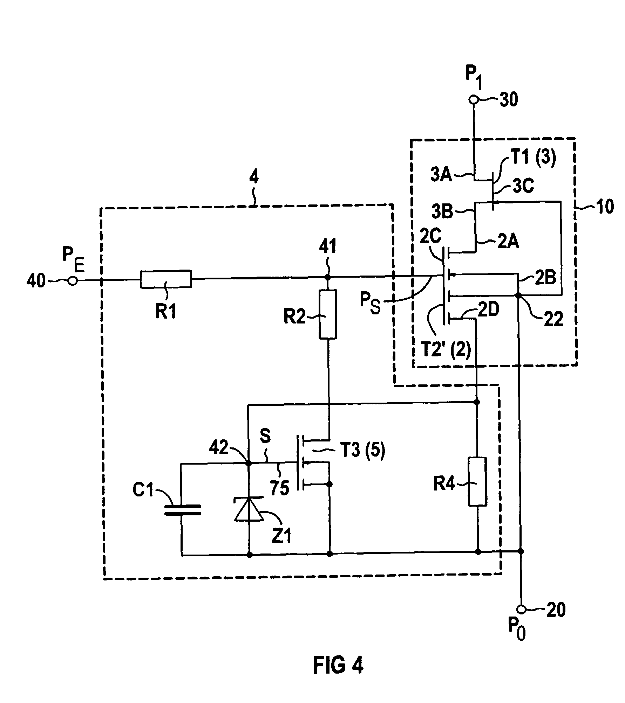

Gemäß FIG 4 wird nicht die Betriebsspannung, sondern der durch die Arbeitsschaltung 10 fließende Betriebsstrom ausgewertet und zum Ausschalten der Arbeitsschaltung 10 im Gefährdungsfall verwendet. Dazu ist nun anstelle eines einfachen MOSFET T2 als Schaltelement 2 ein HITFET vorgesehen. Dieser HITFET T2 ist als selbstsperrender MOSFET ausgebildet und weist zusätzlich zu einem normalen MOSFET einen zusätzlichen Anschluss (Pin) auf, der als Strommonitor (Current Sense) dient. An dem zusätzlichen Stromausgang des HITFET wird ein dem Betriebsstrom (Laststrom) entsprechender Stromwert bereitgestellt. Über den geeignet dimensionierten Abgreifwiderstand R4, der zwischen den Strommonitorausgang des HITFET T2 und den Anschluss 20 geschaltet ist, wird die am Abgreifwiderstand R4 abfallende Abgreifspannung, die direkt proportional dem abzugreifenden Strom am Stromausgang des HITFET T2 entspricht, abgegriffen. Diese Abgreifspannung wird nun von einer analog zu FIG 3 aufgebauten Schaltung aus dem Steuertransistor T3 als Steuerschalter 5, Zenerdiode Z1 und parallel geschaltetem Kondensator C1 sowie Entkopplungswiderstand R2 zum Durchschalten des Gate des HITFET T2 auf das am Anschluss 20 liegende Potential P₀ verwendet, wenn der durch die Arbeitsschaltung 10 fließende Betriebsstrom einen zulässigen Grenzwert überschreitet.

## Patentansprüche

1. Schaltanlage zum Schalten von Wechselströmen in einem Leitungsabzweig mit zwei Schalteinrichtungen, die jeweils umfassen
a) eine Arbeitsschaltung (10),
a1) an die eine Betriebsspannung (U_{B}) anlegbar oder angelegt ist und die
a2) wenigstens ein elektronisches Schaltelement (2), das wenigstens einen Steueranschluss zum Anlegen eines Schaltsignals aufweist und sich abhängig von dem Schaltsignal in einem ausgeschalteten Zustand oder in einem eingeschalteten Zustand befindet, sowie
a3) wenigstens ein elektronisches Schutzelement (3) zum Schutz des im eingeschalteten Zustand befindlichen Schaltelements vor zu hohen Jouleschen Verlusten in einem Gefährdungsfall, insbesondere in einem Überlastfall oder Kurzschlussfall, indem das Schutzelement einen überwiegenden Teil der an der Arbeitsschaltung abfallenden Betriebsspannung trägt, aufweist und
b) Ausschaltmittel (4), die in dem Gefährdungsfall das Schaltelement unter Ausnutzung der in dem Betriebsstrom bzw. der Betriebsspannung enthaltenen Energie selbsttätig in den ausgeschalteten Zustand bringen, wenn der durch die Arbeitsschaltung fließende Betriebsstrom oder die an der Arbeitsschaltung oder an dem Schutzelement abfallende Spannung einen vorgegebenen oberen Grenzwert überschreitet, wobei
c) die Ausschaltmittel den ausgeschalteten Zustand des Schaltelements zumindest für ein vorgegebenes Mindestzeitintervall aufrechterhalten, auch wenn der Gefährdungsfall nicht mehr vorliegt
und wobei
d) die Betriebsspannung eine Wechselspannung ist und das Mindestzeitintervall mindestens so groß wie die halbe Periodendauer der Betriebswechselspannung und vorzugsweise wenigstens so groß wie die volle Periodendauer der Betriebswechselspannung gewählt ist,
e) wobei die zwei Schalteinrichtungen antiseriell in den Leitungsabzweig geschaltet sind.

2. Schaltanlage nach Anspruch 1, bei der die Ausschaltmittel
a) einen Ausgang, der mit dem Steueranschluss des Schaltelements verbunden ist, und
b) zwei Eingänge, die mit der Arbeitsschaltung verbunden sind und an denen die über der Arbeitsschaltung abfallende Betriebsspannung oder ein über dem Schutzelement abfallender Teil der Betriebsspannung oder der durch die Arbeitsschaltung fließende Betriebsstrom oder ein davon abgezweigter Teil abgreifbar oder abgegriffen ist, aufweisen
c) und, wenn der Gefährdungsfall eintritt, an dem Ausgang ein Schaltsignal für das Schaltelement anlegen, bei dem das Schaltelement ausgeschaltet ist oder wird.

3. Schaltanlage nach Anspruch 1 oder Anspruch 2, bei der die Ausschaltmittel einen Steuerschalter (5) umfassen, wobei
a) der Steuerschalter zwischen den Steueranschluss des Schaltelements und einen Schaltpunkt (20) geschaltet ist, an dem ein Signal anliegt oder anlegbar ist, das einem Schaltsignal entspricht, bei dem das Schaltelement ausgeschaltet ist,
b) an einem Steueranschluss des Steuerschalters ein Steuersignal (S) anliegt oder anlegbar ist, das
b1) aus der Betriebsspannung oder dem Betriebsstrom erzeugt oder abgezweigt ist und
b2) derart von der Betriebsspannung oder dem Betriebsstrom abhängt, dass der Steuerschalter eingeschaltet ist, wenn der Gefährdungsfall vorliegt, und ausgeschaltet ist, wenn der Gefährdungsfall nicht vorliegt.

4. Schaltanlage nach Anspruch 3, bei der die Ausschaltmittel eine Spannungsteileinrichtung (Z1, R3, T4) zum Erzeugen des Steuersignals für den Steuerschalter aus der Betriebsspannung umfassen.

5. Schaltanlage nach Anspruch 3 oder Anspruch 4, bei der die Ausschaltmittel einen in den Strompfad für den Betriebsstrom oder für einen zum Betriebsstrom in eindeutiger Beziehung stehenden Abzweigstrom geschalteten Abgreifwiderstand umfassen und das Schaltsignal aus der am Abgreifwiderstand (R4) abgegriffenen Abgreifspannung erzeugen.

6. Schaltanlage nach einem der Ansprüche 3 bis 5, bei der das Signal, das an dem dem Steuerschalter zugeordneten Schaltpunkt anliegt oder anlegbar ist, ein im wesentlichen konstantes elektrisches Potential (P₀) ist, insbesondere Erdpotential oder Massepotential ist.

7. Schaltanlage nach einem der Ansprüche 3 bis 6, bei der zum Steuerschalter in Reihe ein Entkopplungswiderstand (R2) zwischen den Steueranschluss des Schaltelements und den Schaltpunkt geschaltet ist.

8. Schaltanlage nach einem der Ansprüche 3 bis 7, bei der der Steuerschalter wenigstens einen Steuertransistor (T3) umfasst, beispielsweise einen MISFET, insbesondere einen MOSFET.

9. Schaltanlage nach einem der vorhergehenden Ansprüche, bei der die Ausschaltmittel.wenigstens einen Kondensator (C1) zur Aufrechterhaltung des dem ausgeschalteten Zustand des Schaltelements entsprechenden Schaltsignals für das Schaltelement umfassen.

10. Schaltanlage nach Anspruch 9, bei der dem Kondensator Entlademittel zugeordnet sind, insbesondere ein Entladewiderstand parallel geschaltet ist, so dass das Mindestzeitintervall für die Aufrechterhaltung des Schaltsignals von der Entladungszeit des Kondensators abhängt.

11. Schaltanlage nach Anspruch 9 oder Anspruch 10 in Rückbeziehung auf Anspruch 3 oder einen der auf Anspruch 3 rückbezogenen Ansprüche, bei der der Kondensator zwischen den Steueranschluss des Steuerschalters und den zugeordneten Schaltpunkt geschaltet ist.

12. Schaltanlage nach Anspruch 3 oder einem der auf Anspruch 3 rückbezogenen Ansprüche, bei der zwischen den Steueranschluss des Steuerschalters und den zugehörigen Schaltpunkt eine Zenerdiode (Z1) geschaltet ist.

13. Schaltanlage nach Anspruch 11 und Anspruch 12, bei der der Kondensator und die Zenerdiode parallel geschaltet sind.

14. Schaltanlage nach einem der vorhergehenden Ansprüche, bei der die Arbeitsschaltung wenigstens zwei Anschlüsse (20, 30) aufweist, an denen die Betriebsspannung anlegbar ist oder anliegt und zwischen die das Schaltelement und das Schutzelement elektrisch in Reihe geschaltet sind.

15. Schaltanlage nach Anspruch 14 in Kombination mit Anspruch 3 oder einem auf Anspruch 3 rückbezogenen Ansprüche, bei der ein erster der beiden Anschlüsse der Arbeitsschaltung mit dem dem Steuerschalter zugeordneten Schaltpunkt verbunden ist, vorzugsweise auf gleichem elektrischen Potential liegt wie dieser Schaltpunkt.

16. Schaltanlage nach Anspruch 15, bei der zwischen den Steueranschluss des Steuerschalters und einen zweiten der beiden Anschlüsse der Arbeitsschaltung ein spannungsfester Schalter (T4) geschaltet ist.

17. Schaltanlage nach Anspruch 15 oder Anspruch 16, bei der zwischen den Steueranschluss des Steuerschalters und den zweiten Anschluss der Arbeitsschaltung eine Diode (D) geschaltet ist.

18. Schaltanlage nach einem der Ansprüche 15 bis 17, bei der zwischen den Steueranschluss des Steuerschalters und den zweiten Anschluss der Arbeitsschaltung ein Zwischenwiderstand (R3) geschaltet ist.

19. Schaltanlage nach einem der vorhergehenden Ansprüche, bei der das Schaltelement jeder Schalteinrichtung einen HITFET (T2') mit einem Strommonitorausgang (2D) umfasst, wobei die Ausschaltmittel an dem Strommonitorausgang den Betriebsstrom oder ein vom Betriebsstrom eindeutig abhängendes Stromsignal zum Erzeugen des Schaltsignals, das an den Steueranschluss des HITFET angelegt oder anlegbar ist, abgreifen.

20. Schaltanlage nach Anspruch 19 in Kombination mit Anspruch 5 oder einem der auf Anspruch 5 rückbezogenen Ansprüche, bei der der Abgreifwiderstand der Ausschaltmittel an den Strommonitorausgang des HITFET geschaltet ist

21. Schaltanlage nach einem der vorhergehenden Ansprüche mit Steuermitteln (40), die mit dem Steueranschluss des Schaltelements verbunden oder verbindbar sind zum Anlegen eines Schaltsignals für das Schaltelement.

22. Schaltanlage nach Anspruch 21, bei der die Steuermittel den Schaltzustand des Schaltelements bestimmen, wenn nicht der Gefährdungsfall vorliegt, und die Ausschaltmittel den Schaltzustand des Schaltelements bestimmen, wenn der Gefährdungsfall eintritt oder vorliegt.

23. Schaltanlage nach Anspruch 21 oder Anspruch 22, bei der die Steuermittel die Ausschaltmittel aktivieren, wenn das Schaltelement im eingeschalteten Zustand ist, und deaktivieren, wenn das Schaltelement im ausgeschalteten Zustand ist.

24. Schaltanlage nach Anspruch 16 und Anspruch 23, bei der ein Steueranschluss des spannungsfesten Schalters mit den Steuermitteln verbunden ist und die Steuermittel den spannungsfesten Schalter gemeinsam mit dem Schaltelement einschalten.

25. Schaltanlage nach einem der vorhergehenden Ansprüche, bei der das Schutzelement jeder Schalteinrichtung wenigstens einen Halbleiter mit einer Durchbruchsfeldstärke von wenigstens 10⁶ V/cm und/oder einem Bandabstand von wenigstens 2 eV umfasst, insbesondere einen oder mehrere Halbleiter aus der Siliciumcarbid (SiC), vorzugsweise vom α- oder β-Polytyp, Galliumnitrid (GaN), Diamant, Aluminiumnitrid (A1N) und Indiumnitrid (InN) umfassenden Gruppe von Halbleitern.

26. Schaltanlage nach einem der vorhergehenden Ansprüche, bei der das Schaltelement jeder Schalteinrichtung einen oder mehrere Halbleiter aus der Silicium (Si), Galliumarsenid (GaAs), Germanium (Ge) umfassenden Gruppe von Halbleitern aufweist.

27. Schaltanlage nach einem der vorhergehenden Ansprüche, bei der das Schutzelement jeder Schalteinrichtung bei ausgeschaltetem Zustand des Schaltelements dieser Schalteinrichtung und/oder in Sperrrichtung zumindest überwiegend die Betriebsspannung, vorzugsweise im Wesentlichen die gesamte Betriebsspannung, trägt.

28. Schaltanlage nach einem der vorhergehenden Ansprüche, bei der das Schutzelement jeder Schalteinrichtung die anliegende oder abfallende Spannung über wenigstens einen p-n-Übergang und/oder wenigstens einen Schottky-Übergang trägt.

29. Schaltanlage nach einem der vorhergehenden Ansprüche, bei der das Schutzelement und/oder das Schaltelement jeder Schalteinrichtung wenigstens eine JFET-Struktur umfassen bzw. umfasst.

30. Schaltanlage nach einem der vorhergehenden Ansprüche, bei der das Schutzelement und/oder das Schaltelement jeder Schalteinrichtung wenigstens eine MESFET-Struktur umfassen bzw. umfasst.

31. Schaltanlage nach einem der vorhergehenden Ansprüche, bei der das Schaltelement jeder Schalteinrichtung wenigstens eine MISFET-Struktur, insbesondere eine MOSFET-Struktur, umfasst, insbesondere vom selbstsperrenden Typ.

32. Schaltanlage nach Anspruch 29 oder Anspruch 30 und nach Anspruch 31, bei der der Gateanschluss der JFET-Struktur bzw. MESFET-Struktur des Schutzelementes jeder Schalteinrichtung mit dem Sourceanschluss der MISFET-Struktur dieses Schaltelements verbunden ist und der Sourceanschluss der JFET-Struktur bzw. MESFET-Struktur mit dem Drainanschluss der MISFET-Struktur verbunden ist.

33. Schaltanlage nach einem der vorhergehenden Ansprüche, bei der das Schutzelement jeder Schalteinrichtung im Gefährdungsfall einen größeren, vorzugsweise mit steigendem Strom oder prospektiven Strom zunehmenden, Anteil der abfallenden Betriebsspannung trägt als in einem Nennbetrieb bei niedrigeren Betriebsströmen.

34. Schaltanlage nach einem der vorhergehenden Ansprüche, bei der der das Ausschalten im Gefährdungsfall bestimmende obere Grenzwert in einem Sättigungsbereich des Schutzelements jeder Schalteinrichtung liegt.

35. Schaltanlage nach einem der vorhergehenden Ansprüche, bei dem das Schutzelement jeder Schalteinrichtung einen Sättigungsstrom aufweist, der kleiner ist als ein thermischer Grenzstrom des Schaltelements dieser Schalteinrichtung, insbesondere um wenigstens einen Faktor 2, vorzugsweise um wenigstens einen Faktor 3.

36. Schaltanlage nach einem der vorhergehenden Ansprüche, bei der das Schutzelement jeder Schalteinrichtung im Gefährdungsfall wenigstens 70 % und vorzugsweise wenigstens 90 % der Betriebsspannung trägt.

37. Schaltanlage nach einem der vorhergehenden Ansprüche, bei der das Schutzelement jeder Schalteinrichtung den am Schaltelement dieser Schalteinrichtung in dessen eingeschaltetem Zustand abfallenden Teil der Betriebsspannung auf einen maximalen Spannungsgrenzwert begrenzt, insbesondere höchstens 100 V und vorzugsweise höchstens 50 V.

38. Schaltanlage nach einem der vorhergehenden Ansprüche, wobei der Leitungsabzweig ein Leitungsabzweig eines elektrischen Versorgungsnetzes vor einen elektrischen Verbraucher ist.

39. Verfahren zum Betreiben einer Schaltanlage zum Schalten von Wechselströmen in einem Leitungsabzweig umfassend zwei Schalteinrichtungen, insbesondere einer Schaltanlage nach einem der vorhergehenden Ansprüche, wobei jede Schalteinrichtung umfasst
a) eine Arbeitsschaltung,
a1) an die eine Betriebsspannung anlegbar oder angelegt ist und die
a2) wenigstens ein elektronisches Schaltelement, das wenigstens einen Steueranschluss zum Anlegen eines Schaltsignals aufweist und sich abhängig von dem Schaltsignal in einem ausgeschalteten Zustand oder in einem eingeschalteten Zustand befindet, sowie
a3) wenigstens ein elektronisches Schutzelement, das in einem Gefährdungsfall, insbesondere in einem Überlastfall oder Kurzschlussfall, zum Schutz des Schaltelements vor zu hohen Jouleschen Verlusten einen überwiegenden Teil der an der Arbeitsschaltung abfallenden Betriebsspannung trägt, wenn sich das Schaltelement in seinem eingeschalteten Zustand befindet, aufweist,
wobei
b) in dem Gefährdungsfall das Schaltelement unter Ausnutzung der in der Betriebsspannung bzw. dem Betriebsstrom enthaltenen Energie selbsttätig in den ausgeschalteten Zustand gebracht wird, falls der durch die Schaltung fließende Betriebsstrom oder die an der Arbeitsschaltung abfallende Betriebsspannung bzw. der am Schutzelement abfallende Teil der Betriebsspannung einen vorgegebenen oberen Grenzwert überschreitet, wobei
c) die Ausschaltmittel den ausgeschalteten Zustand des Schaltelements zumindest für ein vorgegebenes Mindestzeitintervall aufrechterhalten, auch wenn der Gefährdungsfall nicht mehr vorliegt, und wobei
d) die Betriebsspannung eine Wechselspannung ist und das Mindestzeitintervall mindestens so groß wie die halbe Periodendauer der Betriebswechselspannung und vorzugsweise wenigstens so groß wie die volle Periodendauer der Betriebswechselspannung gewählt ist,
e) wobei die zwei Schalteinrichtungen antiseriell in den Leitungsabzweig geschaltet sind.

## Claims

1. Switching system for switching alternating currents in a line branch having two switching devices which each comprise
a) a working circuit (10),
a1) to which an operating voltage (U_{B}) can be applied or is applied and which has
a2) at least one electronic switching element (2) which has at least one control terminal for applying a switching signal and which, depending on the switching signal, is in a switched off state or in a switched on state, and
a3) at least one electronic protection element (3) for protecting the switching element in its switched on state from excessively high Joule losses in the event of danger, in particular in the event of an overload or a short circuit, in that the protection element bears a predominant part of the operating voltage which drops across the working circuit, and
b) switching off means (4) which, in the event of danger, automatically switch the switching element into the switched off state, using the energy contained in the operating current or the operating voltage, when the operating current flowing through the working circuit or the voltage which drops across the working circuit or the protection element exceeds a predefined upper limiting value,
c) the switching off means maintaining the switched off state of the switching element at least for a predefined minimum time interval even if the dangerous situation is no longer occurring, and
d) the operating voltage being an alternating voltage and the minimum time interval being chosen to be at least as long as half the period length of the operating alternating voltage and preferably at least as long as the entire period length of the operating alternating voltage,
e) the two switching devices being connected in antiserial configuration into the line branch.

2. Switching system according to Claim 1, in which the switching off means have
a) an output which is connected to the control terminal of the switching element, and
b) two inputs which are connected to the working circuit and at which the operating voltage which drops across the working circuit or a part of the operating voltage which drops across the protection element or the operating current flowing through the working circuit or a part thereof which is branched off can be tapped or is tapped,
c) and, if the dangerous situation occurs, they apply a switching signal for the switching element to the output, with which the switching element is switched off.

3. Switching system according to Claim 1 or Claim 2, in which the switching off means comprise a control switch (5),
a) the control switch being connected between the control terminal of the switching element and a switching point (20) to which a signal which corresponds to a switching signal with which the switching element is switched off is applied or can be applied,
b) a control signal (S) being applied or being capable of being applied to a control terminal of the control switch, which control signal (S)
b1) is generated or branched off from the operating voltage or the operating current, and
b2) depends on the operating voltage or the operating current in such a way that the control switch is switched on if the dangerous situation occurs, and switched off if the dangerous situation does not occur.

4. Switching system according to Claim 3, in which the switching off means comprise a voltage divider device (Z1, R3, T4) for generating the control signal for the control switch from the operating voltage.

5. Switching system according to Claim 3 or Claim 4, in which the switching off means comprise a tapping resistor which is connected into the current path for the operating current or for a branched off current which has a uniquely defined relationship with the operating current, and generate the switching signal from the tapping voltage which is tapped at the tapping resistor (R4).

6. Switching system according to one of Claims 3 to 5, in which the signal which is applied or can be applied to the switching point assigned to the control switch is an essentially constant electrical potential (P₀), in particular ground potential or frame potential.

7. Switching system according to one of Claims 3 to 6, in which a decoupling resistor (R2) is connected between the control terminal of the switching element and the switching point and in series with the control switch.

8. Switching system according to one of Claims 3 to 7, in which the control switch comprises at least one control transistor (T3), for example a MISFET, in particular a MOSFET.

9. Switching system according to one of the preceding claims, in which the switching off means comprise at least one capacitor (C1) for maintaining the switching signal corresponding to the switched off state of the switching element - for the switching element.

10. Switching system according to Claim 9, in which discharging means are assigned to the capacitor, in particular a discharging resistor is connected in parallel, with the result that the minimum time interval for maintaining the switching signal depends on the discharging time of the capacitor.

11. Switching system according to Claim 9 or Claim 10, referring back to Claim 3 or one of the Claims referred back to Claim 3, in which the capacitor is connected between the control terminal of the control switch and the assigned switching point.

12. Switching system according to Claim 3 or one of the claims referred back to Claim 3, in which a Zener diode (Z1) is connected between the control terminal of the control switch and the associated switching point.

13. Switching system according to Claim 11 and Claim 12, in which the capacitor and the Zener diode are connected in parallel.

14. Switching system according to one of the preceding claims, in which the working circuit has at least two terminals (20, 30) to which the operating voltage can be applied or is applied and between which the switching element and the protection element are electrically connected in series.

15. Switching system according to Claim 14 in combination with Claim 3 or one of the claims referred back to Claim 3, in which a first terminal of the two terminals of the working circuit is connected to the switching point assigned to the control switch, preferably lies at the same electrical potential as this switching point.

16. Switching system according to Claim 15, in which a voltage-proof switch (T4) is connected between the control terminal of the control switch and a second terminal of the two terminals of the working circuit.

17. Switching system according to Claim 15 or Claim 16, in which a diode (D) is connected between the control terminal of the control switch and the second terminal of the working circuit.

18. Switching system according to one of Claims 15 to 17, in which an intermediate resistor (R3) is connected between the control terminal of the control switch and the second terminal of the working circuit.

19. Switching system according to one of the preceding claims, in which the switching element of each switching device comprises a HITFET (T2') with a current monitor output (2D), the switching off means tapping, at the current monitor output, the operating current or a current signal which is dependent on the operating current in a uniquely defined fashion in order to generate the switching signal which is applied or can be applied to the control terminal of the HITFET.

20. Switching system according to Claim 19 in combination with Claim 5 or one of the claims referred back to Claim 5, in which the tapping resistor of the switching off means is connected to the current monitor output of the HITFET.

21. Switching system according to one of the preceding claims having control means (40) which are connected or can be connected to the control terminal of the switching element in order to apply a switching signal for the switching element.

22. Switching system according to Claim 21, in which the control means determine the switched state of the switching element if the dangerous situation does not occur, and the switching off means determine the switched state of the switching element if the dangerous situation occurs or is occurring.

23. Switching system according to Claim 21 or Claim 22, in which the control means activate the switching off means if the switching element is in the switched on state, and deactivate them if the switching element is in the switched off state.

24. Switching system according to Claim 16 and Claim 23, in which a control terminal of the voltage-proof switch is connected to the control means, and the control means switch on the voltage-proof switch together with the switching element.

25. Switching system according to one of the preceding claims, in which the protection element of each switching device comprises at least one semiconductor with a breakdown field strength of at least 10⁶ V/cm and/or an energy gap of at least 2 eV, in particular one or more semiconductors from the group of semiconductors comprising silicon carbide (SiC), preferably of the α- or β-polytype, gallium nitride (GaN), diamond, aluminum nitride (AlN) and indium nitride (InN).

26. Switching system according to one of the preceding claims, in which the switching element of each switching device has one or more semiconductors from the group of semiconductors comprising silicon (Si), gallium arsenide (GaAs), germanium (Ge).

27. Switching system according to one of the preceding claims, in which, in the switched off state of the switching element of each switching device and/or in the nonconducting direction, the protection element of this switching device bears at least predominantly the operating voltage, preferably essentially the entire operating voltage.

28. Switching system according to one of the preceding claims, in which the protection element of each switching device bears the applied or dropping voltage across at least one p-n type junction and/or at least one Schottky junction.

29. Switching system according to one of the preceding claims, in which the protection element and/or the switching element of each switching device comprise/comprises at least one JFET structure.

30. Switching system according to one of the preceding claims, in which the protection element and/or the switching element of each switching device comprise/comprises at least one MESFET structure.

31. Switching system according to one of the preceding claims, in which the switching element of each switching device comprises at least one MISFET structure, in particular one MOSFET structure, in particular of the normally-off type.

32. Switching system according to Claim 29 or Claim 30 and according to Claim 31, in which the gate terminal of the JFET structure or MESFET structure of the protection element of each switching device is connected to the source terminal of the MISFET structure of this switching element, and the source terminal of the JFET structure or MESFET structure is connected to the drain terminal of the MISFET structure.

33. Switching system according to one of the preceding claims, in which, in the event of danger, the protection element of each switching device bears a greater proportion - preferably increasing as the current or prospective current rises - of the dropping operating voltage than in a rated operating mode in the case of lower operating currents.

34. Switching system according to one of the preceding claims, in which the upper limiting value which determines the switching off in the event of danger lies in a saturation range of the protection element of each switching device.

35. Switching system according to one of the preceding claims, in which the protection element of each switching device has a saturation current which is lower than a thermal limiting current of the switching element of this switching device, in particular by at least a factor of 2, preferably by at least a factor of 3.

36. Switching system according to one of the preceding claims, in which, in the event of danger, the protection element of each switching device bears at least 70% and preferably at least 90% of the operating voltage.

37. Switching system according to one of the preceding claims, in which the protection element of each switching device limits the part of the operating voltage dropping across the switching element of this switching device in its switched on state to a maximum voltage limiting value, in particular at most 100 V and preferably at most 50 V.

38. Switching system according to one of the preceding claims, wherein the line branch is a line branch of an electrical supply power system upstream of an electrical load.

39. Method for operating a switching system for switching alternate currents in a line branch comprising two switching devices, in particular a switching system according to one of the preceding claims, wherein each switching device comprises
a) a working circuit,
a1) to which an operating voltage can be applied or is applied and which has
a2) at least one electronic switching element which has at least one control terminal for applying a switching signal and which, depending on the switching signal, is in a switched off state or in a switched on state, and
a3) at least one electronic protection element which, in the event of danger, in particular in the event of an overload or a short circuit, bears a predominant part of the operating voltage which drops across the working circuit in order to protect the switching element from excessively high Joule losses if the switching element is in its switched on state,
wherein
b) in the event of danger, the switching element is automatically switched into the switched off state, using the energy contained in the operating voltage or the operating current, when the operating current flowing through the circuit or the operating voltage which drops across the working circuit or the part of the operating voltage which drops across the protection element exceeds a predefined upper limiting value,
c) the switching off means maintaining the switched off state of the switching element at least for a predefined minimum time interval even if the dangerous situation is no longer occurring, and
d) the operating voltage being an alternating voltage and the minimum time interval being chosen to be at least as long as half the period length of the operating alternating voltage and preferably at least as long as the entire period length of the operating alternating voltage,
e) the two switching devices being connected in antiserial configuration into the line branch.

## Revendications

1. Installation de distribution pour la commutation de courants alternatifs dans une dérivation de ligne comprenant deux dispositifs commutateurs qui comprennent chacun .
a) un circuit de travail (10),
a1) auquel une tension de fonctionnement (U_{B}) est ou peut être appliquée et qui comporte
a2) au moins un élément commutateur électronique (2), qui comporte au moins une borne de commande pour l'application d'un signal de commutation et qui se trouve dans un état déconnecté ou dans un état connecté en fonction du signal de commutation, ainsi que
a3) au moins un élément protecteur électronique (3) pour la protection de l'élément commutateur se trouvant dans l'état connecté contre de trop grandes pertes ohmiques en présence d'une mise en danger, notamment en cas de surcharge ou en cas de court-circuit, l'élément protecteur supportant une partie prépondérante de la tension de fonctionnement chutant au circuit de travail, et
b) des moyens de coupure (4) qui, en présence d'une mise en danger, mettent automatiquement l'élément commutateur dans l'état déconnecté en utilisant l'énergie contenue dans le courant de fonctionnement ou dans la tension de fonctionnement lorsque le courant de fonctionnement passant dans le circuit de travail ou la tension chutant au circuit de travail ou à l'élément protecteur dépasse une valeur limite supérieure prédéterminée,
c) les moyens de coupure maintenant l'état déconnecté de l'élément commutateur au moins pour un intervalle de temps minimal prédéterminé même si la mise en danger n'existe plus, et
d) la tension de fonctionnement étant une tension alternative et l'intervalle de temps minimal étant choisi au moins aussi grand que la moitié de la période de la tension alternative de fonctionnement et de préférence au moins aussi grand que la totalité de la période de la tension alternative de fonctionnement,
e) les deux dispositifs commutateurs étant branchés en série, tête-bêche, dans la dérivation de ligne.

2. Installation de distribution selon la revendication 1, dans laquelle les moyens de coupure comportent
a) une sortie, qui est reliée à la borne de commande de l'élément commutateur, et
b) deux entrées, qui sont reliées au circuit de travail et auxquelles la tension de fonctionnement chutant au circuit de travail ou une partie de tension de fonctionnement chutant à l'élément protecteur ou le courant de fonctionnement passant dans le circuit de travail ou une partie dérivée de celui-ci est ou peut être prélevé,
c) et, lorsqu'une mise en danger apparaît, appliquent à la sortie pour l'élément commutateur un signal de commutation par lequel l'élément commutateur est déconnecté.

3. Installation de distribution selon la revendication 1 ou 2, dans laquelle les moyens de coupure comprennent un interrupteur de commande (5),
a) l'interrupteur de commande étant monté entre la borne de commande de l'élément commutateur et un point de commutation (20) auquel est ou peut être appliqué un signal qui correspond à un signal de commutation par lequel l'élément commutateur est déconnecté,
b) à une borne de commande de l'interrupteur de commande est ou peut être appliqué un signal de commande (S)
b1) qui est produit ou dérivé à partir de la tension de fonctionnement ou du courant de fonctionnement, et
b2) qui dépend de telle sorte de la tension de fonctionnement ou du courant de fonctionnement que l'interrupteur de commande est connecté en présence d'une mise en danger et déconnecté en l'absence de mise en danger.

4. Installation de distribution selon la revendication 3, dans laquelle les moyens de coupure comprennent un dispositif diviseur de tension (Z1, R3, T4) pour la production du signal de commande pour l'interrupteur de commande à partir de la tension de fonctionnement.

5. Installation de commutation selon la revendication 3 ou la revendication 4, dans laquelle les moyens de coupure comprennent une résistance de prélèvement branchée dans le trajet du courant pour le courant de fonctionnement ou pour un courant dérivé en relation univoque avec le courant de fonctionnement et produisent le signal de commutation à partir de la tension prélevée à la résistance de prélèvement (R4).

6. Installation de distribution selon l'une des revendications 3 à 5, dans laquelle le signal qui est ou peut être appliqué au point de commutation associé à l'interrupteur de commande est un potentiel électrique (P₀) globalement constant, notamment le potentiel de terre ou le potentiel de masse.

7. Installation de distribution selon l'une des revendications 3 à 6, dans laquelle une résistance de découplage (R2) est montée en série avec l'interrupteur de commande entre la borne de commande de l'élément commutateur et le point de commutation.

8. Installation de distribution selon l'une des revendications 3 à 7, dans laquelle l'interrupteur de commande comprend au moins un transistor de commande (T3), par exemple un MISFET, notamment un MOSFET.

9. Installation de distribution selon l'une des revendications précédentes, dans laquelle les moyens de coupure comprennent au moins un condensateur (C1) pour maintenir pour l'élément commutateur le signal de commutation correspondant à l'état déconnecté de l'élément commutateur.

10. Installation électrique selon la revendication 9, dans laquelle sont associés au condensateur des moyens de décharge, notamment une résistance de décharge montée en parallèle, de telle sorte que l'intervalle de temps minimal pour le maintien du signal de commutation dépend du temps de décharge du condensateur.

11. Installation électrique selon la revendication 9 ou la revendication 10 dans la mesure où celle-ci est dépendante de la revendication 3 ou de l'une des revendications rattachées à la revendication 3, dans laquelle le condensateur est monté entre la borne de commande de l'interrupteur de commande et le point de commutation associé.

12. Installation électrique selon la revendication 3 ou selon l'une des revendications rattachées à la revendication 3, dans laquelle une diode Zener (Z1) est montée entre la borne de commande de l'interrupteur de commande et le point de commutation associé.

13. Installation électrique selon la revendication 11 et la revendication 12, dans laquelle le condensateur et la diode Zener sont montés en parallèle.

14. Installation électrique selon l'une des revendications précédentes, dans laquelle le circuit de travail comporte au moins deux bornes (20, 30) auxquelles la tension de fonctionnement est ou peut être appliquée et entre lesquelles l'élément commutateur et l'élément protecteur sont montés électriquement en série.

15. Installation électrique selon la revendication 14 en combinaison avec la revendication 3 ou avec l'une des revendications rattachées à la revendication 3, dans laquelle une première borne des deux bornes du circuit de travail est reliée au point de commutation associé à l'interrupteur de commande, de préférence se trouve au même potentiel électrique que ce point de commutation.

16. Installation électrique selon la revendication 15, dans laquelle un interrupteur à tension invariable (T4) est monté entre la borne de commande de l'interrupteur de commande et une deuxième borne des deux bornes du circuit de travail.

17. Installation électrique selon la revendication 15 ou la revendication 16, dans laquelle une diode (D) est montée entre la borne de commande de l'interrupteur de commande et la deuxième borne du circuit de travail.

18. Installation électrique selon l'une des revendications 15 à 17, dans laquelle une résistance intermédiaire (R3) est montée entre la borne de commande de l'interrupteur de commande et la deuxième borne du circuit de travail.

19. Installation électrique selon l'une des revendications précédentes, dans laquelle l'élément de commutation de chaque dispositif commutateur comprend un HITFET (T2') ayant une sortie de moniteur de courant (2D), les moyens de coupure prélevant à la sortie de moniteur de courant le courant de fonctionnement ou un signal de courant dépendant sans équivoque du courant de fonctionnement pour produire le signal de commutation qui est ou peut être appliqué à la borne de commande du HITFET.

20. Installation électrique selon la revendication 19 en combinaison avec la revendication 5 ou l'une des revendications rattachées à la revendication 5, dans laquelle la résistance de prélèvement des moyens de coupure est branchée sur la sortie de moniteur de courant du HITFET.

21. Installation électrique selon l'une des revendications précédentes, ayant des moyens de commande (40) qui sont ou peuvent être reliés à la borne de commande de l'élément commutateur pour l'application d'un signal de commutation pour l'élément commutateur.

22. Installation électrique selon la revendication 21, dans laquelle les moyens de commande déterminent l'état de commutation de l'élément commutateur en l'absence de mise en danger et les moyens de coupure déterminent l'état de commutation de l'élément commutateur à l'apparition ou en présence d'une mise en danger.

23. Installation électrique selon la revendication 21 ou la revendication 22, dans laquelle les moyens de commande activent les moyens de coupure lorsque l'élément commutateur est dans l'état connecté et les désactivent lorsque l'élément commutateur est dans l'état déconnecté.

24. Installation électrique selon la revendication 16 et la revendication 23, dans laquelle une borne de commande de l'interrupteur à tension invariable est reliée aux moyens de commande et les moyens de commande mettent à l'état connecté l'interrupteur à tension invariable conjointement avec l'élément commutateur.

25. Installation électrique selon l'une des revendications précédentes, dans laquelle l'élément protecteur de chaque dispositif commutateur comprend au moins un semiconducteur ayant une intensité de champ de claquage d'au moins 10⁶ V/cm et/ou un intervalle d'énergie entre bandes d'au moins 2 eV, notamment un ou plusieurs semi-conducteurs du groupe de semi-conducteurs comprenant le carbure de silicium (SiC), de préférence du polytype α ou β, le nitrure de gallium (GaN), le diamant, le nitrure d'aluminium (AlN) et le nitrure d'indium (InN).

26. Installation électrique selon l'une des revendications précédentes, dans laquelle l'élément commutateur de chaque dispositif commutateur comporte un ou plusieurs semi-conducteurs du groupe de semi-conducteurs comprenant le silicium (Si), l'arséniure de gallium (GaAs), le germanium (Ge).

27. Installation électrique selon l'une des revendications précédentes, dans laquelle l'élément protecteur de chaque dispositif commutateur supporte au moins une partie prépondérante de la tension de fonctionnement, de préférence sensiblement la totalité de la tension de fonctionnement, lorsque l'élément commutateur de ce dispositif commutateur est à l'état déconnecté et/ou lorsque lui-même est dans le sens de non-conduction.

28. Installation électrique selon l'une des revendications précédentes, dans laquelle l'élément protecteur de chaque dispositif commutateur supporte la tension existant ou chutant à au moins une jonction p-n et/ou au moins une jonction de Schottky.

29. Installation électrique selon l'une des revendications précédentes, dans laquelle l'élément protecteur et/ou l'élément commutateur de chaque dispositif commutateur comprennent au moins une structure JFET.

30. Installation électrique selon l'une des revendications précédentes, dans laquelle l'élément protecteur et/ou l'élément commutateur de chaque dispositif commutateur comprennent au moins une structure MESFET.

31. Installation électrique selon l'une des revendications précédentes, dans laquelle l'élément commutateur de chaque dispositif commutateur comprend au moins une structure MISFET, notamment une structure MOSFET, notamment du type autobloquant.

32. Installation électrique selon la revendication 29 ou la revendication 30 et selon la revendication 31, dans laquelle la borne de grille de la structure JFET ou MESFET de l'élément protecteur de chaque dispositif commutateur est reliée à la borne de source de la structure MISFET de cet élément commutateur et la borne de source de la structure JFET ou MESFET est reliée à la borne de drain de la structure MISFET.

33. Installation électrique selon l'une des revendications précédentes, dans laquelle l'élément protecteur de chaque dispositif commutateur supporte en présence d'une mise en danger une proportion plus grande, de préférence croissante en cas de courant croissant ou de futur courant croissant, de la tension de fonctionnement chutant que lors du fonctionnement nominal à des courants de fonctionnement inférieurs.

34. Installation électrique selon l'une des revendications précédentes, dans laquelle la valeur limite supérieure déterminant la coupure en présence d'une mise en danger se situe dans une plage de saturation de l'élément protecteur de chaque dispositif commutateur.

35. Installation électrique selon l'une des revendications précédentes, dans laquelle l'élément protecteur de chaque dispositif commutateur comporte un courant de saturation, qui est plus petit qu'un courant limite thermique de l'élément commutateur de ce dispositif commutateur, notamment plus petit d'au moins un facteur 2 et de préférence d'au moins un facteur 3.

36. Installation électrique selon l'une des revendications précédentes, dans laquelle l'élément protecteur de chaque dispositif commutateur supporte en présence d'une mise en danger au moins 70 % et de préférence au moins 90 % de la tension de fonctionnement.

37. Installation électrique selon l'une des revendications précédentes, dans laquelle l'élément protecteur de chaque dispositif commutateur limite à une valeur limite de tension maximale, notamment au maximum 100 V et de préférence au maximum 50 V, la partie de tension de fonctionnement chutant à l'élément commutateur de ce dispositif commutateur lorsque celui-ci est à l'état connecté.

38. Installation électrique selon l'une des revendications précédentes, la dérivation de ligne étant une dérivation de ligne d'un réseau d'alimentation électrique avant un consommateur électrique.

39. Procédé pour faire fonctionner une installation électrique pour la commutation de courants alternatifs dans une dérivation de ligne, comprenant deux dispositifs commutateurs, notamment une installation électrique selon l'une des revendications précédentes, chaque dispositif commutateur comprenant
a) un circuit de travail,
a1) auquel une tension de fonctionnement est ou peut être appliquée et qui comporte
a2) au moins un élément commutateur électronique, qui comporte au moins une borne de commande pour l'application d'un signal de commutation et qui se trouve dans un état déconnecté ou dans un état connecté en fonction du signal de commutation, ainsi que
a3) au moins un élément protecteur électronique qui, en présence d'une mise en danger, notamment en cas de surcharge ou en cas de court-circuit, pour la protection de l'élément commutateur contre de trop grandes pertes ohmiques, supporte une partie prépondérante de la tension de fonctionnement chutant au circuit de travail lorsque l'élément commutateur se trouve dans son état connecté,
b) en présence d'une mise en danger, l'élément commutateur étant automatiquement mis dans l'état déconnecté en utilisant l'énergie contenue dans le courant de fonctionnement ou dans la tension de fonctionnement lorsque le courant de fonctionnement passant dans le circuit de travail ou la tension de fonctionnement chutant au circuit de travail ou la partie de tension de fonctionnement chutant à l'élément protecteur dépasse une valeur limite supérieure prédéterminée,
c) les moyens de coupure maintenant l'état déconnecté de l'élément commutateur au moins pour un intervalle de temps minimal prédéterminé même si la mise en danger n'existe plus, et
d) la tension de fonctionnement étant une tension alternative et l'intervalle de temps minimal étant choisi au moins aussi grand que la moitié de la période de la tension alternative de fonctionnement et de préférence au moins aussi grand que la totalité de la période de la tension alternative de fonctionnement,
e) les deux dispositifs commutateurs étant montés en série, tête-bêche, dans la dérivation de ligne.
